# EUROPEAN PATENT SPECIFICATION

(11) **EP 3 375 826 B1**
(45) Date of publication and mention of the grant of the patent: **27.12.2023**
(21) Application number: 18160587.4
(22) Date of filing: 07.03.2018
(51) Int. Cl.: C09D 5/24, C08G 61/12, C09D 165/00, C08L 65/00, H01G 9/00, H01G 9/028, H01G 9/15, H01B 1/12, C09D 7/40

(54) **COMPOSITION AND METHOD FOR FORMING ELECTROACTIVE POLYMER SOLUTION OR COATING COMPRISING CONJUGATED HETEROAROMATIC POLYMER, ELECTROACTIVE POLYMER SOLUTION, OBJECTS COMPRISING THE ELECTROACTIVE COATING, AND SOLID ELECTROLYTIC CAPACITOR AND METHOD FOR FABRICATING THE SAME**
ZUSAMMENSETZUNG UND VERFAHREN ZUR BILDUNG EINER ELEKTROAKTIVEN POLYMERLÖSUNG ODER -BESCHICHTUNG MIT KONJUGIERTEM HETEROAROMATISCHEM POLYMER, ELEKTROAKTIVE POLYMERLÖSUNG, OBJEKTE MIT DER ELEKTROAKTIVEN BESCHICHTUNG UND FESTELEKTROLYTKONDENSATOR UND VERFAHREN ZUR HERSTELLUNG DAVON
COMPOSITION ET PROCÉDÉ DE FORMATION DE SOLUTION OU REVÊTEMENT DE POLYMÈRE ÉLECTROACTIF COMPRENANT UN POLYMÈRE HÉTÉROAROMATIQUE CONJUGUÉ, SOLUTION DE POLYMÈRE ÉLECTROACTIF, CONDENSATEUR ET OBJET ANTISTATIQUE COMPRENANT LE REVÊTEMENT ÉLECTROACTIF ET CONDENSATEUR ÉLECTROLYTIQUE SOLIDE ET LEUR PROCÉDÉ DE FABRICATION

(30) Priority: 13.03.2017 US 201715456595; 04.12.2017 TW 106142395
(43) Date of publication of application: 19.09.2018
(73) Proprietor: Polym Technology Corporation, Hsinchu, Taiwan (TW)
(72) Inventor: HAN, Chien-Chung, Taiwan, R.O.C. Hsinchu City 30013 (TW); KU, Ting-Chia, Taiwan (R.O.C) Taichung City 413, (TW); CHIANG, Jo-Wen, Taiwan, (R.O.C) Taichung City 412, (TW)
(74) Representative: Haseltine Lake Kempner LLP

(56) References cited:
- WO-A1-2015/192596
- US-A1- 2014 121 326
- US-A1- 2014 293 514
- US-A1- 2017 183 512
- BALTASAR BONILLO ET AL: "Chain-Growth Polymerization of 2-Chlorothiophenes Promoted by Lewis Acids", JOURNAL OF THE AMERICAN CHEMICAL SOCIETY, vol. 134, no. 46, 21 November 2012 (2012-11-21), pages 18916-18919, XP055099518, ISSN: 0002-7863, DOI: 10.1021/ja308498h
- ARUMUGAM BALASUBRAMANIAN ET AL: "Chain-growth cationic polymerization of 2-halogenated thiophenes promoted by Brönsted acids", POLYMER CHEMISTRY, vol. 5, no. 20, 16 June 2014 (2014-06-16), pages 5928-5941, XP055244373, GB ISSN: 1759-9954, DOI: 10.1039/C4PY00521J

## Description

### BACKGROUND OF THE INVENTION

### Field of Invention

This invention relates to conducting polymers, their preparation and their applications, and more particularly relates to a method for forming a conjugated heteroaromatic polymer, to a conjugated heteroaromatic homopolymer or copolymer formed by the method, to a composition for forming an electroactive polymer solution or coating comprising a conjugated heteroaromatic polymer, to an electroactive polymer solution prepared from the composition, to an electroactive coating prepared from the composition, to a capacitor, a supercapacitor, a secondary battery, an electroactive object, an electronic device, a flexible electronic article, a display, an electrochromic window, a touch panel, a touch screen, a corrosion-preventing coating or a conductive ink printing comprising the electroactive coating prepared from the composition, to a method for forming an electroactive polymer solution or coating using the composition, to a capacitor, a supercapacitor, a secondary battery, an electroactive object, an electronic device, a flexible electronic article, a display, an electrochromic window, a touch panel, a touch screen, a corrosion-preventing coating or a conductive ink printing comprising the electroactive coating prepared from the coating forming method, to a method for fabricating a solid electrolytic capacitor using the coating forming method, and to a solid electrolytic capacitor that is fabricated using the fabrication method.

### Description of Related Art

During the past few decades, backbone-conjugated conducting polymers, such as polyacetylenes, polyanilines, polyaromatics, polyheteroaromatics, poly(aromatic vinylene)s and poly(heteroaromatic vinylene)s, have raised great research interests in both industrial and academic communities, because of their great application potentials and their novel electronic, optical, electrooptical, and opto-electronic properties. Conducting polymers have been demonstrated to have great potentials for many important applications, such as antistatic, ESD, EMI-shielding, cable-shielding, radar-shielding, high frequency capacitor, rechargeable battery, anti-corrosion, gas separation membranes, smart window, chemical sensor, bio-sensor, solar cell, light-emitting diode, electrochromic display, field effect transistor, organic memory device, lithography, via-hole electroplating, and nonlinear optical materials.

Among the conjugated conducting polymers, polyheteroaromatics and particularly polythiophenes have attracted great attentions recently due to their easier processability and better thermal stability. Regarding the conventional methods, most of the polyheteroaromatics have been synthesized from heteroaromatics via oxidative polymerization either electrochemically or chemically. For example, US 4,697,001 discloses synthesis of polypyrrole from pyrrole via oxidative chemical polymerization using metal-containing oxidant, such as FeCl₃ or Fe(OTs)₃.

Polythiophenes have been in general prepared either from 2,5-unsubstituted thiophenes or from 2,5-dihalogenated thiophenes. For example, polythiophene can be prepared from thiophene using metal-containing oxidants such as FeCl₃, MoCls, and RuCl₃ (Jpn. J. Appl. Phys. 1984, 23, L899), or from 2,5-dibromothiophene via metal- catalyzed polycondensation polymerization using the combined reagent of Mg metal and Ni(0) catalyst (US 4,521,589). Recently, the metal-catalyzed polycondensation method has been modified by many research groups, such as Reike's and McCullough's, for making regioregular poly(3-substituted thiophenes) from 3-substituted 2,5-dibromo- thiophenes using various combination of metal-containing reagents: such as Li/naphthalene/ZnCl₂/Ni(II) or Pd(0) complex (US 5,756,653), organomagnesium reagent/Ni(II)-complex (US 6,166,172), organomagnesium reagent/ZnCl₂/Ni(II)-complex (US 7,572,880), and organomagnesium reagent/MnCl₂Ni(II) complex (US 2010/0234478A1).

Up to now, there is only one reported prior method of preparing polythiophene from 2-bromothiophenes (US 6,602,974). For example, McCullough indicated that the above regioregular poly(3-substituted thiophenes) can also be made from 3-substituted 2-bromo-thiophene via a three-step reaction by treating the monomer in the first step with a strong base LDA (lithium diisopropylamine, prepared freshly from the reaction of diisopropylamine with n-butyl lithium) under cryogenic temperatures at -40 °C for 40 minutes, followed by the addition of MgBr₂ at -60°C for about 1 hour in the second step, and then by the addition of Ni(II)-complex at -5°C in the third step, and finally allowed the reaction to proceed at room temperature for additional 18 hours.

All the above mentioned prior methods have encountered the disadvantage of being contaminated with substantial amount of transitional metal impurities that can cause detrimental effects to the optimal performance, long term stability, and the lifetime of their application articles and devices. Furthermore, most of the conventional methods involve use of either a strong base (such as organolithium reagent, organomagnesium reagent, and LDA) or a reactive metal (such as activated Zn metal, Mg metal, and Li metal), or in some cases the use of both reagents. These reagents are reactive toward the monomers that contain a proton group having a pKₐ value of less than about 40 (such as S-H, O-H, N-H, acetylenic proton, α-hydrogen to a carbonyl group or to other electron-withdrawing group, and all the C-H groups except those of alkyl, alkoxy, phenyl, and vinyl) and also reactive toward electrophilic functional groups (such as carbonyl, carbonate, nitrile, imino, nitro, nitroso, sulfoxide, sulfinyl, and sulfonyl, phosphonyl, phosphinyl, epoxy, alkyl halide, and other similar groups).

Such reactivity will cause great limitations on the allowable functional groups appearing on the thiophene monomers. Similar limitations would also occur to the conventional chemical oxidative polymerization method, wherein the employed strong oxidant causes the undesirable oxidation side reactions to some of the functional groups. The high reactivity of both the above strong base and active metal will also greatly limit the applicable reaction and/or processing solvent media. These strong bases and reactive metals are also in general moisture- and air-sensitive, which requires the use of expensive and complicated production apparatus, facility, handling and manufacturing process. These reactive reagents also cast great industrial potential hazards. In addition, the above methods often involve the use of either the cryogenic temperatures (such as -40°C to -78°C) or the reflux temperatures for long hours, which would further increase the production costs and energy consumptions. Further, these transition metal complexes are not only very expensive but also environmentally concerned.

Though a specific polythiophene derivative, poly(3,4-ethylenedioxythiophene) (PEDOT), has been prepared via a catalyst-free solid-state oxidative polymerization by heating the solid crystals of 2,5-dibromo-3,4-ethylenedioxythiophene (DBEDOT) as a monomer at some elevated temperatures below its melting temperature (96-97°C), as described in J. Am. Chem. Soc. 2003, 125, 15151-15162, the same polymerization did not proceed in its melt or solution state. Such solid-state polymerization method is also only applicable to limited cases due to its unique requirements for the steric arrangement between two neighboring dihalogenated monomers within the crystal. In the same report, they had also found that the addition of protonic acid catalyst (such as HBr) did not lead to any changes to the dibromo-monomer (see the footnote 24 thereof).

On the other hand, US 6,891,016 discloses that in presence of protonic acid or Lewis acid, non-brominated 3,4-ethylenedioxythiophene (EDOT) changes significantly to yield an equilibrium reaction mixture that contains unreacted monomer (~50%) and non-conjugated dimeric and trimeric thiophenes (-50%), instead of polymers. Though US 7,951,901 discloses that the mixture of EDOT and DBEDOT can somehow undergo polymerization in presence of protonic acid or Lewis acid, the polymerization requires heating at high temperatures (80-90°C) for long time (5-11 h) and only gives PEDOT in a poor yield (40-60%) with a rather low conductivity of 10⁻²-10⁻⁷ S/cm. Furthermore, this method is only applicable to 3,4-dialkoxy-substituted thiophenes.

Thus, there is a great need for an effective, energy saving, and environmentally friendly method for making polythiophenes and polyheteroaromatics in general.

While, regarding the applications of conductive polymer, US 4,803,596 discloses that a conductive polymer may be used as the solid electrolyte of a solid electrolytic capacitor. In the method, the positive foil of an electrolytic capacitor is dripped with a monomer solution and an oxidant solution sequentially, and the monomer is polymerized by the oxidant under proper condition. However, because the conductive polymer monomer is not fully and homogeneously mixed with the oxidant, the reaction and the resultant coating are not uniform.

US 4,910,645 discloses that a series of specific polythiophenes can apply to the electrolyte of solid state electrolytic capacitors. The method includes dipping a capacitor element in a pre-mixed solution of a thiophene monomer and an oxidant and then polymerizing the thiophene monomer at higher temperature. However, the stability of the mixture at room temperature decreases significantly if high concentration of the monomer and/or the oxidant is used. Therefore, the method uses a large amount of solvent to dilute the concentration of the monomer and the oxidant, so only a very little amount of conductive polymer coating forms in every single impregnation- polymerization cycle. Hence, many cycles are required to generate enough amounts of conductive polymer for filling the pores and spaces in the capacitor element.

US 6,056,899 discloses a process that uses a kind of cyclic ether (such as THF) to mix with an Fe(III) oxidant for forming a coordination complex to reduce the oxidation ability of the oxidant so that the mixture solution of the monomer and the oxidant is kept stable. After the capacitor element is impregnated with the mixture, the cyclic ether is evaporated at a higher temperature to release the oxidant for inducing polymerization of the monomer. Since the cyclic ether used in the invention (such as THF) has little ability as a polymerization retardant to stabilize the mixture solution of the monomer and the oxidant, a large amount of such cyclic ether (ca. 40-60 wt%) is employed in order to stabilize the mixture solution, and consequently dilutes the mixture solution. As a result, many impregnation-polymerization cycles (e.g., 12 cycles) are still required to accumulate enough amounts of conductive polymer for filling the pores and spaces in the capacitor element.

The current solid capacitors still suffer many technological drawbacks, such as having rather low percentage of pore-filling and low percentage of surface coverage, thus, resulted in a low value of static capacitance (which are in general in the 40-60% range of the theoretical static capacitance) and rather weak mechanical strength (due to the presence of high percentages of the unfilled or partly filled pores within the fragile dielectric layer). Owing to the inefficient pore-filling and surface coverage nature, the solid capacitors require the use of much longer anodic foil to deliver the same given value of static capacitance. Hence, the length of the counter cathode foil and the two separators also have to be much increased accordingly, leading to much increased overall volume and size of the capacitors. The fact that the dielectric layer has a high percentage of the unfilled or partly filled pores also make the conventional solid capacitors very susceptible to the vibrational stress and mechanical impact during their applications, leading to higher failure rate and shorter service lifetime. The conventional solid capacitors also suffer the disadvantages of having poor thermal stability and with rather low withstanding voltages, probably caused by the presence of the large amounts of the transition metal contaminants due to the use of large quantity of Fe(III) tosylate (in theory, 2.5 equivalent is required to use) as the oxidant for performing the oxidative polymerization of the EDOT (i.e., 3,4-ethylenedioxythiophene) monomer. All these disadvantages have greatly limited the performance, service lifetime, and the application potentials of the conventional solid capacitors. US 2014/0121326A1 relates to a method for forming conjugated heteroaromatic homopolymer and copolymer, and products thereof.
US 2014/0293514A1 relates to a composition and method for forming an electroactive coating comprising a conjugated heteroaromatic polymer, to a capacitor and antistatic object comprising the electroactive coating, to a solid electrolytic capacitor and method for fabricating the same.
WO2015/192596A1 relates to a composition and method for forming electroactive polymer solution or coating comprising conjugated heteroaromatic polymer, to electroactive polymer solution, to a capacitor and antistatic object comprising the electroactive coating, and to a solid electrolytic capacitor and method for fabricating the same.

### SUMMARY OF THE INVENTION

Accordingly, this invention provides an effective, low-cost, environmentally friendly method for forming a conjugated heteroaromatic polymer or copolymer.

This invention also provides a conjugated heteroaromatic polymer or copolymer that can be formed by using the method of this invention.

This invention provides a composition for forming an electroactive polymer coating as described in the claims.

This invention further provides a method for forming an electroactive polymer coating, comprising: a) contacting the composition for forming an electroactive polymer coating as described in the claims with a substrate; and b) conducting at least one of a step of raising a temperature of the substrate, a step of evaporating partly the solvent in the composition, and a step of evaporating partly or completely the polymerization retardant in the composition, so as to initiate and/or continue polymerization on a surface of the substrate and/or in a hole of the substrate and form a conjugated heteroaromatic polymer.

This invention further provides an electroactive coating comprising a conjugated heteroaromatic polymer wherein the conjugated heteroaromatic polymer is prepared from the composition for forming an electroactive polymer coating as described in the claims, and the electroactive coating further comprises a part of the polymerization retardant in the composition.

This invention further provides an electroactive polymer solution comprising a conjugated heteroaromatic polymer, wherein the conjugated heteroaromatic polymer is prepared from the composition for forming an electroactive polymer coating as described in the claims, and the electroactive polymer solution further comprises a part of the polymerization retardant in the composition.

This invention further provides an application article containing the electroactive coating described in the claims. The application article may be one of various electroactive objects (such as antistatic, electrostatic dissipation, EMI shielding, infrared, radio frequency and microwave absorbing shields, and smart cards), electronic devices (such as LED, field effect transistors, organic memory devices, solar cell devices, photovoltaic cells, supercapacitors, and sensors), a flexible electronic article (such as flexible electronic membranes, contacts, wires, electrodes, connectors, and devices), a display and electrochromic window devices for electrochromic displays, electroluminescent displays, liquid crystal displays, solar windows, smart windows, electrochromic sunroofs, electrochromic windows, liquid crystal windows, touch panels, and touch screens, a corrosion-prevention coating for corrodible materials, or a conductive ink printing.

This invention further provides a method for fabricating a solid electrolytic capacitor, comprising: forming an anode; forming a dielectric layer on the anode; and forming, as a solid electrolyte, an electroactive coating on the dielectric layer with the coating forming method as described in the claims.

This invention further provides a solid electrolytic capacitor that is fabricated using the fabrication method described in the claims.

This invention also provides a high performance solid capacitor, having high static capacitance, low ESR, low DF, low LC, high thermal stability, high mechanical strength, small volume, and long shelf lifetime and service lifetime.

This invention also provides a high performance solid capacitor that are particularly suitable for the applications in automobile electrical and electronic equipment, audio-video appliance, computer servers, LED lighting system, LED bulb, smart phone, power supply, power generator, the inverters and/or converters for solar cells and photovoltaic cells.

This invention also provides a general purpose composition and polymerization method for making both low voltage and high voltage solid capacitors.

This invention is based on the discovery of the unusual high polymerization reactivity of a heteroaromatic compound bearing with only one leaving group at position 2 or 5 of the herteroaromatic ring, which can be initiated by an acid catalyst to give a highly conjugated and conductive polyheteroaromatic, comprising a polymer chain having a predominant 2,5-linkage backbone structure and having a leaving group Y or Z (the same one as the monomer) or a derivative thereof at the chain end(s).

In a method for forming a conjugated heteroaromatic polymer, at least one compound of formula (1) is polymerized using an acid as a catalyst, 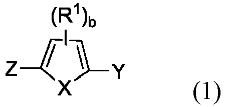 wherein X is selected from the group consisting of S, O, Se, Te, PR² and NR², wherein R² is selected from the group consisting of hydrogen, and substituted or unsubstituted alkyl, aryl, heteroaryl, alkanoyl, and aryloyl groups. Y is hydrogen (H), or a precursor of a good leaving group Y⁻ whose conjugate acid (HY) has a pKₐ of less than 45. Z is hydrogen (H), silyl, or a precursor of good leaving group Z⁻ whose conjugate acid (HZ) has a pKₐ of less than 45. The value b is 0, 1 or 2. Each R¹ is a substituent. When b=2, the two R¹ are the same or different and may joint together to form a substituted or unsubstituted aliphatic, aromatic, or heteroaromatic ring, which may include one or more heteroatoms and/or divalent moieties selected from nitrogen, sulfur, sulfinyl, sulfonyl, phosphorus, selenium, ester, carbonyl, oxygen, and so on. The at least one compound of formula (1) being polymerized comprises at least one compound of formula (1) with Z=H and Y≠H.

The inventors also found that an oligomer or polymer formed by polymerizing a compound of formula (1) with Z=H and Y≠H as above also has polymerization reactivity. Accordingly, a derivative method for forming a conjugated heteroaromatic polymer is described, wherein at least one compound of formula (2) is polymerized using an acid as a catalyst, 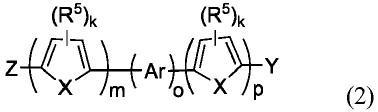 wherein X, Y and Z are defined as above. Ar is a substituted or unsubstituted, mono- or poly-nuclear, aryl or heteroaryl ring. The values m and p are each independently an integer equal to or greater than 1, and o is an integer equal to or greater than 0. Each k is independently 0, 1 or 2. Each R⁵ is a substituent, wherein any two R⁵ on the same ring or on two neighboring rings, or R⁵ and a substituent group on a neighboring Ar ring, may join together to form a substituted or unsubstituted aliphatic, aromatic, or heteroaromatic ring, which may include one or more heteroatoms and/or divalent moieties selected from nitrogen, sulfur, sulfinyl, sulfonyl, phosphorus, selenium, ester, carbonyl, oxygen, and so on. The at least one compound of formula (2) being polymerized comprises at least one compound of formula (2) with Z=H and Y≠H.

A compound of formula (2) can also be used as the polymerization promoter for a compound of formula (1). For example, a less reactive compound of formula (1) with Z≠H and Y≠H or with Z=H and Y=H can be first mixed with a small and predetermined amount of a compound of formula (2), following by the addition of the acid catalyst. Owing to the greater conjugation extent and thus the greater electronic density of the compound of formula (2), the acid catalyst will first react with the compound of formula (2) that will then promote the coupling reaction between the compound of formula (2) and the compound of formula (1), thus initiating the polymerization of the compound of formula (1). Moreover, the inventors also found that a less reactive compound of formula (1) selected from the group consisting of compounds of formula (1) with Z≠H and Y≠H and compounds of formula (1) with Z=H and Y=H can also react with an oligomer or polymer that is formed by polymerizing a compound of formula (1) with Z=H and Y≠H to further elongate the polymer chain. Accordingly, it is possible to polymerize a first compound of formula (1) with Z=H and Y≠H first to form a polymer chain, followed by the addition of a second compound of formula (1) with Z=H and Y≠H, Z≠H and Y≠H, or Z=H and Y=H, but with a different combination set of X, R¹ and b to further elongate the polymer chain forming a different block and thus to yield a diblock copolymer. Then, the first compound or a third compound of formula (1) with Z=H and Y≠H, Z≠H and Y≠H, or Z=H and Y=H, but having a still different combination set of X, R¹ and b can be added to form a further block. Thus, a triblock copolymer with either an A-B-A or an A-B-C structural configuration can be prepared, wherein A, B, C are representing different polymer blocks. Likewise, a multi-block copolymer can be similarly prepared by simply controlling the addition sequence and reaction timing for each different monomeric compound of formula (1).

Accordingly, described herein is a conjugated heteroaromatic block copolymer including a fragment expressed by formula (3): 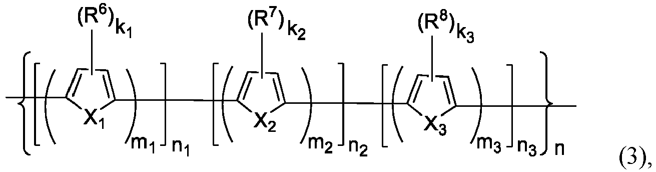 wherein n is an integer equal to or greater than 1, m₁, m₂ and m₃ are independently integral equal to or greater than 2, and n₁, n₂ and n₃ are independently 1 or 0. X₁, X₂ and X₃ are the same or different, and are independently selected from the group consisting of S, O, Se, Te, PR² and NR², wherein R² is selected from the group consisting of hydrogen, and substituted and unsubstituted alkyl, aryl, heteroaryl, alkanoyl, and aryloy groups. The values k₁, k₂, k₃ are independently 0, 1 or 2. R⁶, R⁷ and R⁸ are the same or different substituents and can be selected from permissible R⁵ groups, wherein any two R⁶ or two R⁷ or two R⁸ groups on the same ring may join together to form another ring. In formula (3), there is a proviso that any two neighboring blocks have different repeat units.

Furthermore, the above derivative method comprising polymerizing at least one compound of formula (2) produces a conjugated heteroaromatic copolymer that comprises a fragment expressed by formula (4): 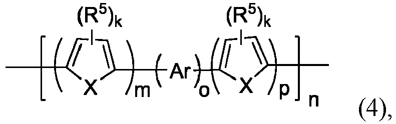 wherein n is an integer equal to or greater than 4, X is the same or different at each occurrence and is defined as above, and Ar, k, R⁵, m, o and p are defined as above.

The conjugated heteroaromatics copolymers expressed by formula (4) may be alternative copolymers having two or more different types of repeat units alternatively appeared along the polymer chain.

The conducting polymer solutions or coatings described herein can be provided by any suitable method known in the art, from the preformed conjugated polymer product or from the composition of this invention.

The composition for forming a conjugated heteroaromatic polymer coating of this invention comprises the aforementioned at least one compound of formula (1) as a monomer that comprises at least one compound of formula (1) with Z=H and Y≠H or the aforementioned at least one compound of formula (2) as a monomer that comprises at least one compound of formula (2) with Z=H and Y≠H, an acid as a polymerization catalyst selected from the group consisting of a protic acid, a polymeric acid and a non-transitional Lewis acid (i.e., a Lewis acid that is free of transition metal elements), and at least one functional component selected from the group of a solvent, a polymerization retardant, a polymer binder, a dopant, a latent dopant, a plasticizer, an impact modifier, a reinforcing filler, a blowing agent, a crosslinking agent, an ultraviolet stabilizer, a flame retardant, a photoresist, a thickening agent, a defoaming agent, an emulsifier, a surfactant, and a dispersion stabilizer. The at least one functional component contains at least the polymerization retardant and the polymer binder, and the polymerization retardant comprises at least one Lewis base having a stronger basicity than the monomer and slows down or inhibits polymerization activity of a mixture solution of the monomer and the acid as the polymerization catalyst. The polymer binder (a) is not a polymerization retardant, or (b) comprises a polymeric acid functioning as the acid as the polymerization catalyst and functioning as the dopant. The concentration of the monomer in the composition ranges from 1 wt% to 99 wt%, the molar ratio of the acid as the polymerization catalyst to the monomer ranges from 0.0001 to 20, the molar ratio of the polymerization retardant to the acid as the polymerization catalyst is greater than 0.0001, and the weight ratio of the polymer binder to the monomer ranges from 0.001 to 500.

The at least one functional component contains at least a polymerization retardant comprising at least one Lewis base having a stronger basicity than the monomer. The at least one functional component contains at least a polymerization retardant and a polymer binder.

The method for forming an electroactive polymer solution as described herein includes: placing the above composition in a reactor, and conducting at least one of a step of raising the temperature of the composition, a step of evaporating partly the solvent in the composition, and a step of evaporating partly or completely the polymerization retardant used as the functional component in the composition, so as to initiate and/or continue polymerization to form an electroactive polymer solution comprising a conjugated heteroaromatic polymer.

The method for forming an electroactive coating of this invention includes: contacting the above composition with a substrate, and conducting at least one of a step of raising the temperature of the substrate, a step of evaporating partly the solvent in the composition, and a step of evaporating partly or completely the polymerization retardant used as the functional component in the composition, so as to initiate and/or continue polymerization on a surface of the substrate and/or in a pore of the substrate and form a conjugated heteroaromatic polymer.

Regarding to contacting the above composition with a substrate, any suitable method known in the art can be used, including, but not being limited to, solution casting, melt casting, dipping, soaking, impregnation, dropping, dripping on, squirting, spraying, doctor blade coating, roller coating, rotogravure printing, sponge roller coating, spin-coating, painting, and printing.

Alternatively, the method for forming an electroactive coating of this invention includes using the electroactive polymer solution, which is prepared from the above preparation method or from the composition of this invention, to form a coating via any suitable method known in the art, including, but not being limited to, solution casting, melt casting, dipping, soaking, impregnation, dropping, dripping on, squirting, spraying, doctor blade coating, roller coating, rotogravure printing, sponge roller coating, spin-coating, painting, and printing.

The method for fabricating a solid electrolytic capacitor of this invention includes the following steps at least. An anode is formed. A dielectric layer is formed on the anode. An electroactive coating is formed on the dielectric layer to serve as a solid electrolyte. The solid electrolyte may be considered as a true cathode. The electroactive coating can be provided by the methods described above, such as by solution casting or melt casting on a substrate or an object based on a preformed conjugated heteroaromatics polymer made by the polymerization method of this invention, or by solution casting, dipping, soaking, impregnation, dropping, dripping on, squirting, spraying, doctor blade coating, roller coating, rotogravure printing, sponge roller coating, spin-coating, painting, or printing on a substrate or an object with a polymerization solution preformed from the composition of this invention. In one preferred embodiment, the electroactive coating is formed from the composition via *in-situ* polymerization, with the electroactive coating forming method mentioned above.

Because no air- and moisture-sensitive reagents are needed in the method for forming a conjugated heteroaromatic polymer, the method is friendly in chemical handling. Moreover, since the method needs a simple production facility and the manufacturing process is simple and safe, the manufacturing cost is low. In addition, since the polymerization can be effectively conducted at ambient temperature, the method is also energy-saving.

Also, the manufacturing process of the method of this invention is heavy-metal free, so that the method is environmentally friendly. The polymer product is transition-metal-free or may even be metal ion free, so that the application shelf life thereof is longer.

In addition, since the electroactive coating of this invention is prepared from a composition containing at least one acid catalyst selected from the group consisting of a protic acid, a non-transitional Lewis acid, and a polymeric acid, and is therefore also substantially free of transitional metal contaminants. The amount of the transition metal contaminants in the resultant electroactive coating is expected to be low and would be at least lower than 1 wt%, and preferably lower than 0.1 wt%, and more preferably lower than 0.01 wt%, and most preferably lower than 0.001 wt%. The application products built based on these transitional-metal-free electroactive coating should also have long application shelf life.

The yield of the polymerization reaction is also high because of the high reactivity of the heteroaromatic ring having only one leaving group at its position 2 or 5. Moreover, since the coupling reaction between two rings has a higher directional_preference, a fairly regioregular conductive polymer, with predominantly 2,5-linkage backbone structure, can be obtained.

Furthermore, the method of this invention is convenient in making block copolymers, which are, for example, potential good materials with broad range of UV-vis-NIR absorption for solar cell application. The method of this invention can also be used to produce an extremely high molecular weight polymer that may be used as an extra high mechanical strength material, due to the reactivity of the oligomer or polymer formed by the method with additional monomers fed thereto.

The method of this invention also has high tolerability to functional groups, such as acid, carbonyl, nitrile, -OH, or any acidic proton of pKₐ < 40. In addition, the polymer product of the method can also have other advantageous properties, such as high solubility (>1-10 wt%) in many common organic solvents (such as CHCl₃, CH₂Cl₂, TCE, DCE, THF, NMP, DMF, DMSO, CS₂, xylene, toluene, chlorobenzene, and o-dichlorobenzene), good film forming properties, strong film adhesion with various substrates such as plastic, glass, metal, and metal oxide, high conductivity, and ability for self-assembling. Furthermore, the electronic or electrooptical application devices (such as LEDs and capacitors) fabricated with the transitional-metal-free polymer product of this invention may have longer service lifetime and/or much enhanced performance properties (such as raising up the breakdown voltage and/or thermal stability to render a capacitor device more suitable for high working voltage and/or high working temperature applications).

Moreover, by including an effective polymerization retardant in the functional additive, such as a Lewis base having a stronger basicity than the monomer, the stability of the composition for forming an electroactive coating of this invention can be greatly enhanced, which allows the use of a composition having a much higher monomer concentration (as high as a neat monomer liquid, as described in Example 44 in the prior application Ser. No. 14/306,251, filed on June 17, 2014, now allowed) so that a conductive polymer coating having a sufficient thickness may be formed in a single impregnation-polymerization cycle. Furthermore, by concurrently including a polymerization retardant and a polymer binder as the functional components in the composition of this invention, it would render the solid capacitor of this invention with a super high quality having a higher static capacity, a lower ESR, a lower DF, a higher mechanical strength, higher interfacial adhesions between the electroactive coating and all the component layers of the capacitor element, a higher thermal stability, and a longer shelf lifetime and service lifetime. Since these high quality solid capacitors can survive under tough working environments, such as high vibrational stresses and mechanical impacts, high working temperatures, and/or high working voltages, they are particularly suitable for the applications of automobile electrical and electronic equipment, audio-video apparatuses, LED lamps and LED lighting systems, smart phone, high voltage and high capacity power generators and power supply. The much improved mechanical strength and thermal stability of the electroactive coating also render them particularly suitable for various flexible or nonflexible electronic articles, displays, electrochromic window devices, supercapacitors, secondary batteries, photovoltaic devices, solar cells, and other outdoor static and/or dynamic electroactive application objects. In addition, the composition and/or electroactive solution of this invention are also particularly suitable for corrosion-prevention coating and conductive ink printing applications.

In order to make the aforementioned and other objects, features and advantages of this invention comprehensible, a preferred embodiment accompanied with figures is described in detail below.

### BRIEF DESCRIPTION OF THE DRAWINGS

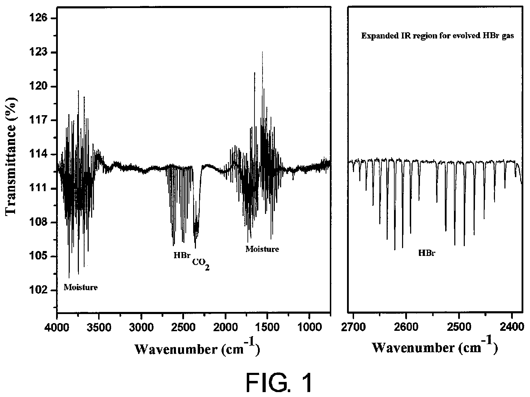

FIG. 1 is the IR spectrum of the HBr gas generated from the polymerization reaction.
FIGs. 2A-2C illustrate, in a cross-sectional view, an application of the method of this invention wherein the polymerization of at least one compound of formula (1) or (2) is performed over a surface of a substrate to form an organic conductive film.

### DESCRIPTION OF EMBODIMENTS

It is first noted that the term "a compound of formula (1)" is sometimes called "a compound (1)" hereafter for simplicity. The same rule applies to formula (2).

The group X, X₁, X₂ or X₃ in the heteroaromatic ring of the above formulae (1)-(4) is selected from the group consisting of S, O, Se, Te, PR² and NR², wherein R² is selected from the group consisting of hydrogen, and substituted or unsubstituted alkyl, aryl, heteroaryl, alkanoyl, and aryloyl groups.

The group Y in the above formulae (1)-(2) is hydrogen (H), or a precursor of a good leaving group Y⁻ whose conjugate acid (HY) has a pKₐ of less than 45, preferably less than about 30, more preferably less than about 20, most preferably less than about 6. Useful leaving groups Y include halogen-based, O-based, N-based, 5-based, P-based and weakly basic C-based substituent groups. The preferred leaving group Y is selected from the group consisting of iodide, bromide, chloride, fluoride, sulfonates, sulfinates, phosphates, phosphinates, phosphonates, carboxylates, cyano, nitro, nitrite, carbonates, amido, imido, amide, imide, amino, alkylamino, arylamino, heteroarylamino, amine, alkylamine, arylamine, heteroarylamine, acetylacetone, alkoxy, and aryloxy. The more preferred leaving group Y is selected from the group consisting of iodide, bromide, chloride, fluoride, sulfonates, phosphates, phosphinates, phosphonates, carboxylates, carbonates, amide, imide, amino, amine, alkylamine, arylamine, heteroarylamine, acetylacetone, alkoxy, and aryloxy.

The group Z in the above formulae (1) and (2) is hydrogen (H), silyl, or a precursor of good leaving group Z⁻ whose conjugate acid (HZ) has a pKₐ of less than 45, preferably less than about 30, more preferably less than about 20, most preferably less than about 6. Useful leaving groups Z include halogen-based, O-based, N-based, 5-based, P-based, Si-based and weakly basic C-based substituent groups. The preferred Z group is selected from the group consisting of hydrogen, silyl, iodide, bromide, chloride, fluoride, sulfonates, sulfinates, phosphates, phosphinates, phosphonates, carboxylates, cyano, nitro, nitrite, carbonates, amido, imido, amide, imide, amino, alkylamino, arylamino, heteroarylamino, amine, alkylamine, arylamine, heteroarylamine, acetylacetone, alkoxy, and aryloxy. The more preferred Z group is selected from the group consisting of hydrogen, silyl, iodide, bromide, chloride, fluoride, sulfonates, phosphates, phosphinates, phosphonates, carboxylates, carbonates, amide, imide, amino, amine, alkylamine, arylamine, heteroarylamine, acetylacetone, alkoxy, and aryloxy.

It is essential in the method of this invention that the at least one compound of formula (1) or (2) being polymerized includes at least a compound of formula (1) or (2) with Z=H and Y≠H, which acts to trigger the polymerization reaction. A compound of formula (1) or (2) with Z=H and Y=H and/or a compound of formula (1) or (2) with Z≠H and Y≠H, which cannot be polymerized alone with the acid catalyst, can however be polymerized in the presence of the compound of formula (1) or (2) with Z=H and Y≠H due to the triggering effect.

### <Substituents R on the Heteroaromatic Ring>

Each R¹ in formula (1), each R⁵ in formula (2), each of R⁶, R⁷ and R⁸ in formula (3), or each R⁵ in formula (4), is independently selected from the group consisting of deuterium, alkyl, alkenyl, alkynyl, alkenynyl, aryl, alkylaryl, arylalkyl, allyl, benzyl, alkoxy, aryloxy, cycloalkyl, cycloalkenyl, cycloalkynyl, cycloalkenynyl, alkanoyl, aryloyl, aryloyloxy, alkanoyloxy, alkylthio, arylthio, alkylthioalkyl, alkylthioaryl, arylthioaryl, mercaptoalkoxy, mercaptoaryloxy, mercaptoalkyl, mercaptoaryl, mercaptoarylthio, mercaptoalkylthio, mercaptoalkylarylalkyl, mercaptoarylalkylaryl, halo, hydroxyl, hydroxyalkyl, hydroxyaryl, cyano, nitro, alkylsilyl, arylsilyl, alkoxysilyl, aryloxysilyl, mercapto, epoxy moieties, amino, aminoalkyl, aminoaryl, amido, amidoalkyl, amidoaryl, arylamino, diarylamino, alkylamino, dialkylamino, alkylarylamino, alkoxyalkyl, aryloxyalkyl, alkoxycarbonyl, alkoxysilylalkyl, alkylsilylalkyl, alkoxysilylaryl, alkylsilylaryl, heterocyclic ring, heteroaromatic ring, alkylsulfinyl, arylsulfinyl, alkylsulfonyl, arylsulfonyl, alkylsulfinylalkyl, alkylsulfonylalkyl, alkylcarboxylate, alkylsulfinate, alkyl sulfonate, alkylphosphonate, alkylphosphate, arylcarboxylate, aryl sulfinate, aryl sulfonate, arylphosphonate, arylphosphate; derivatives of various acid functional groups including phosphonic acid, phosphinic acid, phosphoric acid, boric acid, carboxylic acid, sulfinic acid, sulfonic acid, sulfamic acid, and amino acid, wherein the acid derivatives may include ester, amide and metal salt; aliphatic moieties having a repeating unit of -(OCH₂CH₂)_{q}OCH₃, -(OCH₂CH(CH₃))_{q}OCH₃, -(CH₂)_{q}CF₃, -(CF₂)_{q}CF₃ or -(CH₂)_{q}CH₃, wherein q≥1; and a moiety of (OR³)ᵣOR⁴, wherein R³ is a divalent C₁₋₇ alkylene moiety, R⁴ is C₁₋₂₀ alkyl, 1≤r≤50. All the above mentioned substituent groups may be further substituted with allowable functional groups, such as ester, amino acid, halo, epoxy, amino, silyl, nitro, alkyl, aryl, alkoxy, aryloxy, alkylthio, and arylthio groups.

Any two R¹ groups in formula (1), or any two R⁵ groups on the same ring or on the neighboring rings in formula (2) and (4), or any R⁵ together with the substituent group on the neighboring Ar ring in formula (2) and (4), or any two R⁶ or any two R⁷ or any two R⁸ groups on the same ring or on neighboring rings in formula (3) may joint together to form a substituted or unsubstituted alkylene, alkenylene, or alkynylene chain completing an aromatic, heteroaromatic, heteroalicyclic or alicyclic ring system, which may include one or more heteroatoms and/or divalent moieties such as nitrogen, sulfur, sulfinyl, sulfonyl, phosphorus, selenium, ester, carbonyl, and oxygen, wherein permissible substituents are the aforementioned functional groups.

### <Aromatic Group Ar in Formula (2)/(4)>

The aromatic group Ar in formula (2)/(4) is substituted or unsubstituted, mono- or poly-nuclear, aryl or heteroaryl. The aryl and heteroaryl preferably denote a mono-, bi- or tri-cyclic aromatic or heteroaromatic group with up to 25 C atoms that may also comprise condensed rings and is optionally substituted. Preferred aryl groups include, without limitation, benzene, biphenylene, triphenylene, naphthalene, anthracene, binaphthylene, phenanthrene, pyrene, dihydropyrene, chrysene, perylene, tetracene, pentacene, benzpyrene, fluorene, indene, indenofluorene, spirobifluorene, and the like. Preferred heteroaryl groups include, without limitation, 5-membered rings like pyrrole, pyrazole, imidazole, 1,2,3-triazole, 1,2,4-triazole, tetrazole, furan, thiophene, selenophene, oxazole, isoxazole, 1,2-thiazole, 1,3-thiazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 6-membered rings like pyridine, pyridazine, pyrimidine, pyrazine, 1,3,5-triazine, 1,2,4-triazine, 1,2,3-triazine, 1,2,4,5-tetrazine, 1,2,3,4-tetrazine, 1,2,3,5-tetrazine, and fused systems like carbazole, indole, isoindole, indolizine, indazole, benzimidazole, benzotriazole, purine, naphthimidazole, phenanthrimidazole, pyridimidazole, pyrazinimidazole, quinoxalinimidazole, benzoxazole, naphthoxazole, anthroxazole, phenanthroxazole, isoxazole, benzothiazole, benzofuran, isobenzofuran, dibenzofuran, quinoline, isoquinoline, pteridine, benzo-5,6-quinoline, benzo-6,7-quinoline, benzo-7,8-quinoline, benzoisoquinoline, acridine, phenothiazine, phenoxazine, benzopyridazine, benzopyrimidine, quinoxaline, phenazine, naphthyridine, azacarbazole, benzocarboline, phenanthridine, phenanthroline, thieno[2,3b]thiophene, thieno[3,2b]thiophene, dithienothiophene, dithienopyridine, isobenzothiophene, dibenzothiophene, benzothiadiazothiophene, or combinations thereof. The heteroaryl groups may be substituted with allowable functional groups, such as acid, ester, amino acid, halo, epoxy, amino, silyl, nitro, alkoxy, aryloxy, alkylthio, arylthio, alkyl, fluoro, fluoroalkyl, or further aryl or heteroaryl substituents.

It is also noted that a compound of formula (2) with one or more Ar units can be prepared using the conventional synthetic methods know in the art. Alternatively, certain compounds of formula (2) can be prepared from corresponding compounds of formula (1) via the polymerization method of this invention.

### <Acid catalyst>

The acids for implementing this invention are selected from the group consisting of a non-transitional Lewis acids, a protic acid, and a polymeric acid.

Useful non-transitional Lewis acids include the salts of non-transitional elements such as boron salts, tin salts, aluminum salts, antimony salts, arsenic salts, bismuth salts, germanium salts, tellurium salts, and thallium salts. Exemplary boron-containing Lewis acid includes boron trihalides, such as boron trifluoride, boron trichloride and boron tribromide; and the complexes of boron trihalides, such as boron trifluoride dihydrate, boron trifluoride diethyl etherate, boron trifluoride-alcohol complex, boron trifluoride-methyl sulfide complex, boron trifluoride-phosphoric acid complex, and the like; with the boron trifluoride and its complexes being the preferable. Exemplary tin-containing Lewis acid includes tin(IV) chloride, tin(IV) bromide, tin(IV) fluoride, tin(IV) sulfate, and the like; with tin(IV) chloride being the preferable.

The non-transitional Lewis acid is used as the polymerization catalyst in the present invention, such as one of the above boron-containing and tin-containing Lewis acids, so that the electroactive polymer solution or coating formed with the method or from the composition of this invention is substantially transitional-metal free.

Any protic acid can be used as long as they can protonate at least one reactive staring molecule to convert it into a protonated form that would then initiate the coupling reaction with another non-protonated starting molecule. The useful protic acid may have an acidic proton with a pKₐ value of less than 20, preferably with a pKₐ value of less than 10, more preferably with a pKₐ value of less than 5, most preferably with a pKₐ value of less than 4. The lowest acidity required for an acid to function as an effective acid catalyst in this invention depends on the basicity of the reactive starting molecules used. In general, the higher the basicity of the reactive starting molecules, the lower the acidity of the protic acid may be required to initiate the polymerization. While for a given reactive starting molecule, the stronger acid catalyst will lead to a higher number of initiation and a faster chain propagation rate. Useful protic acid includes inorganic acids, organic acids, and polymeric acids. Illustrative useful inorganic acids includes HF, HCl, HBr, HI, HNO₃, HNO₂, HBF₄, HPF₆, HSbF₆, H₂SO₄, H₂SO₃, H₂SeO₄, H₂SeO₃, H₂TeO₃, HClO₄, HClO₃, HClO₂, HClO, H₃AsO₄, H₃SbO₄, and H₃BiO₄, fluorosulfuric acid, nitrosylsulfuric acid, superacids like fluoroantimonic acid and magic acid, sulfamic acid, phosphorous acid, phosphinic acid, phosphonic acid, phosphoramidic acid, phosphorodiamidic acid, phosphoric acid, pyrophosphoric acid, triphosphoric acid, oligophosphoric acid, polyphosphoric acid, metaphosphoric acid, trimetaphosphoric acid, polymetaphosphoric acid, and the like. Useful organic acids are substituted and unsubstituted aliphatic, cycloaliphatic, aromatic, or heteroaromatic compounds containing at least one acid functional group selected from the group consisting of sulfonic acid, sulfinic acid, sulfamic acid, sulfanilic acid, sulfuric acid, hydrogen sulfate, bisulfate, carboxylic acids, carbonic acid, phosphonic acid, phosphinic acid, phosphoric acid, hydrogen phosphate, dihydrogen phosphate, phosphonous acid, phosphonamidic acid, boric acid, and amino acid. Illustrative useful organic acids includes methanesulfonic acid, trifluoromethanesulfonic acid, ethanesulfonic acid, propanesulfonic acid, butanesulfonic acid, nonanesulfonic acid, decanesulfonic acid, dodecanesulfonic acid, hexadecanesulfonic acid, cetylsulfonic acid, isethionic acid, camphorsulfonic acid, camphorsulfinic acid, benzenesulfonic acid, benzenedisulfonic acid, benzenetrisulfonic acid, dihydroxybenzenedisulfonic acid, toluenesulfonic acid, octylbenzenesulfonic acid, dodecylbenzenesulfonic acid, methylisopropylbenzenesulfonic acid, mesitylenesulfonic acid, methoxybenzenesulfonic acid, 4-hydroxy-5-isopropyl-2-methylbenzenesulfonic acid, phenylaminobenzenesulfonic acid, naphthalenesulfonic acid, naphthalenedisulfonic acid, naphthalenetrisulfonic acid, hydroxynaphthalenesulfonic acid, dihydroxynaphthalenesulfonic acid, dihydroxynaphthalenedisulfonic acid, dinonylnaphthalenesulphonic acid, dinonylnaphthalenedisulphonic acid, anthracenesulfonic acid, phenanthrenesulfonic acid, chrysenesulfonic acid, pyrenesulfonic acid, tetracenesulfonic acid, pentacenesulfonic acid, naphthoquinonesulfonic acid, phthalocyanine sulfonic acid, phthalocyanine disulfonic acid, phthalocyanine tetrasulfonic acid, biphenylsulfonic acid, biphenyldisulfonic acid, haloalkanesulfonic acid, perfluorobutanesulfonic acid, perfluorooctanesulfonic acid, sulfanilic acid, sulfophthalic acid, sulfoacetic acid, 2-sulfoethyl acrylate, 3-sulfopropyl acrylate, 2-sulfoethyl methacrylate, 3-sulfopropyl methacrylate, vinylsulfonic acid, sulfosalicyclic acid, lauryl sulfate, dodecyl sulfuric acid, dodecyl hydrogen sulfate, trifluoroacetic acid, difluoroacetic acid, fluoroacetic acid, perfluoropropionic acid, perfluorobutyric acid, perfluorooctanoic acid, trichloroacetic acid, dichloroacetic acid, chloroacetic acid, haloalkanoic acid, perhaloalkanoic acid, oxalic acid, malonic acid, malic acid, citric acid, phthalic acid, formic acid, ascorbic acid, tartaric acid, methylsulfamic acid, nitrilotriacetic acid, nitrilotris(methylene)triphosphonic acid, methylenediphosphonic acid, phenylphosphonic acid, phenylphosphinic acid, ethylphosphonic acid, butylphosphonic acid, *t*-butylphosphonic acid, methyl dihydrogen phosphate, dimethyl hydrogen phosphate, naphthyl dihydrogen phosphate, phenyl phosphate, diphenyl phosphate, mono-(2-ethylhexyl) phosphate, bis(2-ethylhexyl) phosphate, di(2-ethylhexyl)phosphoric acid, and the like. Preferred organic acids are halogen substituted alkanoic acids, phosphorus-containing acids such as phosphonic acid, phosphinic acid, phosphoric acid, sulfur-containing acids such as sulfonic acids, sulfinic acids, sulfamic acids. More preferred organic acids are phosphorus-containing acids such as phosphonic acid, phosphinic acid, and phosphoric acid; sulfur-containing acids such as sulfonic acids, sulfinic acids, and sulfamic acids. Most preferred organic acids are sulfonic acids and phosphonic acid.

Useful polymeric acids can be organic and inorganic oligomers and polymers being substituted with more than one acid functional groups selected from the group consisting of sulfonic acid, sulfinic acid, sulfamic acid, sulfanilic acid, sulfuric acid, hydrogen sulfate, bisulfate, carboxylic acids, carbonic acid, phosphonic acid, phosphinic acid, phosphoric acid, hydrogen phosphate, dihydrogen phosphate, phosphonous acid, phosphonamidic acid, boric acid, and amino acid.

Illustrative useful polymeric acids include substituted and unsubstituted polystyrenesulfonic acid, polyacrylic acid, polymethacrylic acid, polymaleic acid, polyvinylsulfonic acid, sulfonated polystyrenes, sulfonated poly(vinyl naphthalene), sulfonated poly(vinyl arene)s, sulfonated poly(vinyl heteroarene)s, sulfonated copolymers or terpolymers that comprise at least one aromatic functional group or one heteroaromatic functional group or one styrene repeat unit, oligophosphoric acid, polyphosphoric acid, oligometaphosphoric acid, polymetaphosphoric acid, poly(ethylene phosphate), poly(propylene phosphate), and the like. The more preferred polymeric acids are substituted and unsubstituted polystyrenesulfonic acid, polyvinylsulfonic acid, sulfonated-polystyrenes, sulfonated copolymers or terpolymers that comprise at least one aromatic functional group or one heteroaromatic functional group or one styrene repeat unit, polyphosphoric acid, poly(ethylene phosphate), and poly(propylene phosphate), and combination mixtures, copolymers and terpolymers thereof.

The acid described above can be used either alone or as a mixture with one or more other acid(s). The amount of acid used can vary widely, depending on the desirable nature and properties that are intended to build in with the products. The molar ratio of the acid as the polymerization catalyst to the monomer ranges from 0.0001 to 20. In general, a higher amount of acid catalyst will induce a higher number of initiations, leading to a smaller average molecular weight; while a lower amount of acid catalyst will induce a lower number of initiations, leading to greater average molecular weight. The leaving group released as in the form of HY (such as HBr or other acid) during the coupling polymerization step may participate to a certain extent as an effective acid catalyst for the subsequent polymerization steps. The extent of involvement of the in-situ released HY in the polymerization reaction varies, depending on the polarity and the basicity of starting material and the employed solvent. In general, the greater the basicity and the polarity of the starting material and/or the reaction solvent medium is, the higher extent of the involvement of the in-situ released HY will be. Thus, an amount of acid catalyst as high as 20 equivalents (based on the mole number of the reactive starting molecules) can be used, if a low molecular weight polymers or oligomers such as dimers or trimers are intended to obtain. While, an amount of acid catalyst as low as 0.0001 equivalents can also be used, if a high molecular weight polymer is intended to obtain or whenever the released HY can serve as an effective supplementary acid catalyst for performing the polymerization.

### <Solvents>

The reactive starting molecules used to implement this invention can be either in a neat liquid form, a pure solid form, or a molten form, or as a solute form dissolving or dispersing in a given solvent medium. For example, a neat liquid of reactive starting material can be used to mix with a liquid acid catalyst, such as trifluoroacetic acid or a solid acid such as toluenesulfonic acid. The resultant mixture may form a single miscible liquid phase at the first moment, or it can form initially a two phase liquid/liquid or liquid/solid mixture systems that may then gradually turned into a single phase mixture as the polymerization proceeding with time. The reaction can also be carried out by mixing a solid starting material in a crystal form or in a fine powdery form with a liquid acid catalyst; the surrounding acid catalyst molecule will then initiate the polymerization starting from the surface of the solid. The starting material can also be an emulsion form or a small liquid drop form dispersing in a solvent medium with or without the aid of a surfactant, the added acid catalyst can then initiate the polymerization from the surface of or within the emulsion micelles or liquid drops, resulting in nano-sized and/or micrometer-sized conducting polymer particles. The reactive starting material can also be provided as thin liquid or solid coating layer that may be induced to undergo polymerization by contacting the coating with an acid vapor such as HCl, HBr, BF₃, or trifluoroacetic acid, resulting in a thin conducting layer of polyheteroaromatics in situ.

Any solvent or solvent mixture can be used as the desirable solvent medium in implementing the present invention as long as it can help dissolve or disperse, mix or contact the reactive starting molecules and acid catalyst. Illustrative of useful solvents include alcohols, linear and cyclic ethers, esters, hydrocarbons, halogen-containing hydrocarbons, substituted aromatics, ketones, amides, nitriles, carbonate esters, sulfoxides and other sulfur containing solvents, nitro substituted alkanes and aromatics, water or mixtures thereof.

Exemplary alcohols include methanol, ethanol, propanol, butanol, pentanol, hexanol, heptanol, octanol, nonanol, decanol, undecanol, dodecanol, isopropanol, isobutanol, t-butanol, and the like. Illustrative linear and cyclic ethers include tetrahydrofuran, tetrahydropyran, 2-methyltetrahydrofuran, diethyl ether, diglyme, glyme, dipropyl ether, diisopropyl ether, dibutyl ether, methyl butyl ether, diphenyl ether, dioxane, diethylene glycol, ethylene glycol (EG), and the like. Illustrative aliphatic hydrocarbons include hexane, heptane, octane, nonane, decane, and the like. Exemplary halogen-containing hydrocarbons, include dichloromethane, chloroform, 1,2-dichloroethane, carbon tetrachloride, dichloroethane, dibromoethane, trichloroethane, tribromoethane, tetrachloroethane, and the like. Illustrative substituted aromatics include xylene, anisole, toluene, benzene, cumene, mesitylene, phenol, cresol, dichlorobenzene, chlorobenzene, and the like. Exemplary ketones include acetone, propanone, butanone, pentanone, hexanone, heptanone, octanone, acetophenone, and the like. Illustrative amides include dimethylformamide, *N,N*-dimethylacetamide, *N*-methyl-2-pyrrolidinone and the like. Exemplary nitriles include acetonitrile, propionitrile, benzonitrile, butyronitrile, and the like. Illustrative sulfoxides and other sulfur containing solvents include dimethylsulfoxide, and the like. Illustrative nitro substituted alkanes and aromatics include nitromethane, nitroethane, nitropropane, nitroisopropane, nitrobenzene, and the like. Exemplary carbonate esters include dimethyl carbonate, diethyl carbonate, dipropyl carbonate, dibutyl carbonate, dipentylcarbonate, diphenyl carbonate, ethyl methyl carbonate, ethyl butyl carbonate, methyl phenyl carbonate, butylene carbonate, propylene carbonate, ethylene carbonate, and the like. Exemplary esters include ethyl acetate, methyl acetate, methyl propanoate, ethyl propanoate, methyl butanoate, ethyl butanoate, propyl butanoate, methyl pentanoate, ethyl pentanoate, methyl hexanoate, ethyl hexanoate, propyl hexanoate, methyl heptanoate, methyl octanoate, phenyl acetate, dimethyl terephthalate, dimethyl isophthalate, dimethylphthalate, methyl benzoate, ethyl benzoate, and the like. In general, the amount of solvent or solvent mixture employed for the reaction media is not critical, so long as the reactive starting molecules and acid catalyst can be dissolved or dispersed, mixed or contacted with each other.

### <Reaction Temperature and Reaction Time>

The useful reaction temperatures to implement this invention can vary widely, depending on the nature of the starting molecules and the purpose of applications. Since this invention provides a very effective method for making polyheteroaromatics, most of the polymerization can undergo efficiently to give essentially quantitative yields within rather short time interval (such as 5 to 30 minutes) at ambient temperatures, without the need of heating or cooling. So, from the economical point of view, it is most desirable to perform the reaction at ambient temperature, which is the most convenient and energy saving approach. While for the most reactive starting molecules, such as 2-bromo-3,4-alkylenedioxythiophene, or 2-bromo-furans, or 2-bromopyrroles, it may be desirable to use some lower reaction temperatures (such as 0 °C) for gaining more fine-tuning controls on the polymerization behaviors. For those least reactive starting molecules, such as 2-bromothiophenes bearing with directly attached electron-withdrawing groups, such as ketone, carboxylic acid, sulfonic acid groups, it may be desirable to use some higher reaction temperatures (30-60°C) to increase the polymerization rate for shortening the overall reaction time. For the case of making conductive coating via the *in-situ* polymerization of a surface coating layer of the starting molecules via the included latent acid complex (such as acid-base complex), a heating treatment step may be needed to help remove the base and meanwhile release the acid catalyst for inducing the polymerization.

The useful reaction time to implement this invention can vary widely, depending on the nature of the starting molecules and the targeted properties of the polymer intended to obtain. In general, under optimal conditions, short reaction time (such as 0.1 to 2.5 hours) can provide polymers (having essentially quantitative yields) with narrower molecular weight distribution (i.e., having a small polydispersity, PDI, value) and higher regioregularity, while the longer reaction time can provide higher molecular weight polymer (also with essentially quantitative yields) but also with broader molecule weight distribution (i.e., with higher PDI values).

### <Repeat unit>

In general, the number of repeat units of the obtained conjugated heteroaromatic homopolymers or copolymers is not critical and may vary widely. The greater the number of repeat units, the greater the viscosity and molecular weight of the conjugated homopolymer or copolymer will be. In those applications where a conjugated homopolymer or copolymer of relatively low molecular weight and viscosity is required, such materials may be used, and in those applications where a conjugated homopolymer or copolymer of relatively high molecular weight and viscosity is required, then such materials can be used. The number of repeat units is at least about 4. The upper limit can vary widely depending on the desired molecular weight and viscosity and the required degree of processibility, such as melt processibility, solution processibility and the like. In the preferred embodiments of the invention, the number of repeat units is at least about 10, and in the particularly preferred embodiments, the number of repeat units is at least about 20. Amongst the particularly preferred embodiments, most preferred are those embodiments in which the number of repeat units is at least about 25.

### <Different Embodiments for the Polymerization Procedure>

In some descriptions of the method for forming a conjugated heteroaromatic polymer, at least one compound of formula (1) is polymerized using an above-mentioned acid as a catalyst, 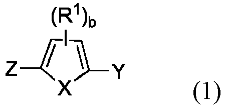 wherein X is selected from the group consisting of S, O, Se, Te, PR² and NR², wherein R² is selected from the group consisting of hydrogen, and substituted and unsubstituted alkyl, aryl, heteroaryl, alkanoyl, and aryloyl groups. Y is hydrogen (H), or a precursor of a good leaving group Y whose conjugate acid (HY) has a pKₐ of less than 45. Z is hydrogen (H), silyl, or a good leaving group Z⁻ whose conjugate acid (HZ) has a pKₐ of less than 45. The value b is 0, 1 or 2. R¹ is defined as above. The at least one compound of formula (1) being polymerized comprises at least one compound of formula (1) with Z=H and Y≠H.

In an embodiment, the at least one compound of formula (1) being polymerized consists of a single compound of formula (1) with Z=H and Y≠H. The conjugated heteroaromatic polymer thus obtained comprises a homopolymer chain having a predominant 2,5-linkage backbone structure and having a leaving group Y (the same one as the monomer) or a derivative thereof at the chain end(s).

In another embodiment, the at least one compound of formula (1) being polymerized consists of two or more compounds of formula (1) with Z=H and Y≠H. It is possible that the two or more compounds of formula (1) with Z=H and Y≠H contain different combination sets of X, R¹ and b and are added in sequence to form two or more different polymer blocks.

In another embodiment, the more reactive compound of formula (1) with Z=H and Y≠H is polymerized with at least one less reactive compound selected from the group consisting of compounds (1) with Z≠H and Y≠H and compounds (1) with Z=H and Y=H. The compound of formula (1) with Z=H and Y≠H and the at least one less reactive compound may be polymerized at the same time. Alternatively, the more reactive compound of formula (1) with Z=H and Y≠H is polymerized first to form a polymer chain, and then the at least one less reactive compound is added to react with a terminal of the polymer chain and elongate the polymer chain. In still another embodiment, the at least one less reactive compound comprises two or more compounds, and the two or more compounds are added in a sequence to form two or more different polymer blocks.

In an embodiment, the at least one less reactive compound is selected from the group consisting of compounds (1) with Z≠H and Y≠H, or from the group consisting of compounds (1) with Z=H and Y=H.

In another embodiment, the at least one less reactive compound comprises at least one compound of formula (1) with Z≠H and Y≠H and at least one compound of formula (1) with Z=H and Y=H.

In the above embodiments, the compound of formula (1) with Z=H and Y≠H and the at least one less reactive compound may have different groups X. For example, a thiophene-based compound (X=S) as the compound of formula (1) with Z=H and Y≠H can be polymerized with a pyrrole-based compound (X=N) as the at least one less reactive compound.

In addition, when a compound (1) with Z=H and Y≠H is polymerized with another compound (1) with Z=H and Y≠H or with at least one less reactive compound as defined above, either a homopolymer or a copolymer can be obtained. Specifically, when each of X, R¹ and k of the compounds is fixed, a homopolymer is obtained; when either of X, R¹ and k is not fixed, a copolymer is obtained.

In some other embodiments of the method of this invention, at least one compound of formula (2) is polymerized using an above-mentioned acid as a catalyst, 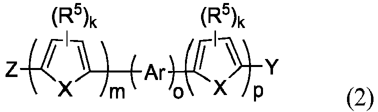 wherein X, Y, Z and Ar are defined as above. The values m and p are each independently an integer equal to or greater than 1, and o is an integer equal to or greater than 0. Each k is independently 0, 1 or 2. R⁵ is defined as above, wherein any two R⁵ on the same ring or on neighboring rings, or any R⁵ and a substituent group on a neighboring Ar ring, may join together to form another ring. The at least one compound of formula (2) being polymerized comprises at least a compound with Z=H and Y≠H.

In an embodiment, the at least one compound of formula (2) being polymerized comprises a plurality of compounds of formula (2) with Z=H and Y≠H having different m+p values, with o=0 and m+p≥4. This corresponds to a case where oligomeric or polymeric molecules are further polymerized with each other to form polymers with greater molecular weights.

In another embodiment, with o=0, the at least one compound of formula (2) being polymerized comprises a plurality of compounds with Z=H and Y≠H having different m+p values each being equal to or greater than 4, and at least one less reactive compound selected from the group consisting of compounds of formula (2) with Z≠H, Y≠H and m+p=1, and compounds of formula (2) with Z=H, Y=H and m+p=1. This corresponds to a case where monomers are added to oligomeric or polymeric chains to elongate the chain.

The conjugated heteroaromatic copolymer formed from the method using at least one compound of formula (1) may include a fragment expressed by formula (3): 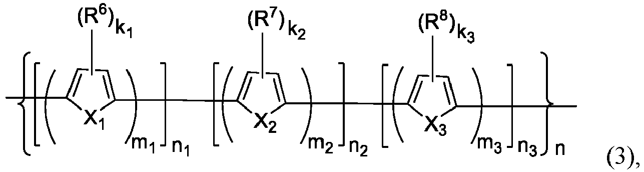 wherein n is an integer equal to or greater than 1, m₁, m₂ and m₃ are independently integral equal to or greater than 2, and n₁, n₂ and n₃ are independently 1 or 0. X₁, X₂, and X₃ are the same or different, and are independently selected from the group consisting of S, O, Se, Te, PR² and NR², wherein R² is selected from the group consisting of hydrogen, and substituted and unsubstituted alkyl, aryl, heteroaryl, alkanoyl, and aryloyl groups. The values k₁, k₂ and k₃ are independently 0, 1 or 2. R⁶, R⁷, and R⁸ are the same or different substituent and can be selected from permissible R⁵ groups, wherein any two R⁶ or two R⁷ or two R⁸ groups on the same ring may join together to form another ring. In formula (3), there is a proviso that any two neighboring blocks have different repeat units.

An example of such a copolymer is formed by first polymerizing a compound having a specific set of X₁, R⁶ and k₁ and with Z=H and Y≠H to form a polymer chain, and then adding at least one less reactive compound defined as above and having a different combination set of X₂, R⁷ and k₂ to react with the terminals of the polymer chains and elongate the polymer chains to form a diblock copolymer. Similarly, another less reactive defined as above and having a different combination set of X₃, R⁸ and k₃ can then be added subsequently to react with the terminals of the polymer chains and elongate the polymer chains to form a triblock copolymer. If the combination set of X₃, R⁸ and k₃ is different from the combination set of X₁, R⁶ and k₁, then an ABC type of triblock copolymer is yielded. Whereas, if the combination set of X₃, R⁸ and k₃ is the same as the combination set of X₁, R⁶, and k₁, then an ABA type of triblock copolymer is yielded. Likewise, multi-block copolymers of any types can be similarly prepared.

In some examples of the conjugated heteroaromatic copolymer, one of X¹ and X² represents S and the other of X¹ and X² represents O, Se, Te, PR² and NR².

The conjugated heteroaromatic copolymer formed from the method using at least one compound of formula (2) includes a fragment expressed by formula (4): 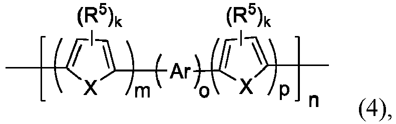 wherein n is an integer equal to or greater than 4. X is the same or different at each occurrence, and is selected from the group consisting of S, O, Se, Te, PR² and NR², wherein R² is selected from the group consisting of hydrogen, and substituted or unsubstituted alkyl, aryl, heteroaryl, alkanoyl, and aryloyl groups. Ar is a substituted or unsubstituted, mono- or poly-nuclear, aryl or heteroaryl ring. The value k is 0, 1 or 2. Each R⁵ is a substituent, wherein the two R⁵ on the same ring or on neighboring rings, or R⁵ and a substituent group on a neighboring Ar ring, may join together to form another ring. The values m and p are each independently an integer equal to or greater than 1, and o is an integer equal to or greater than 0.

The conjugated heteroaromatics copolymers may be alternative copolymers having two or more different types of repeat units alternatively appeared along the polymer chain.

### <Dopants>

The conjugated homopolymer or copolymer can be either in the neutral undoped (nonconductive) form(s) or in the conductive and doped forms with various doping degrees.

In the case of conductive and doped forms, the heteroaromatic homopolymer or copolymer can be doped with a suitable dopant to render the polymer electrically conductive. Dopants for use in general can be such materials which are known in the art for use in doping conjugated backbone homopolymer or copolymers to form conductive or semi-conductive polymers, such as oxidizing dopants can be used. Illustrative of useful oxidizing dopants are AsF₅, NO⁺ and NO₂⁺ salts (such as NOBF₄, NOPF₆, NOSbF₆, NOAsF₆, NO₂BF₄, NO₂PF₆, NO₂A_{S}F₆, NO₂SbF₆, and the like), HClO₄, HNO₃, H₂SO₄, SO₃, I₂, and Fe(III) salts (such as FeCl₃, Fe(OTs)₃, Fe (CF₃SO₃)₃, and the like). Illustrative of other dopants includes protonic acid dopants. Such dopants include inorganic acids, such as hydrofluoric acid, hydroiodic acid, nitric acid, boric acid, sulfuric acid, HNO₂, HBF₄, HPF₆, HSbF₆, H₂SO₃, H₂SeO₄, H₂SeO₃, H₂TeO₃, HClO₄, HClO₃, HClO₂, HClO, H₃AsO₄, H₃SbO₄, H₃BiO₄, nitrosylsulfuric acid, fluorosulfuric acid, superacids like fluoroantimonic acid and magic acid, sulfamic acid, phosphorous acid, phosphinic acid, phosphonic acid, phosphoramidic acid, phosphorodiamidic acid, phosphoric acid, pyrophosphoric acid, triphosphoric acid, oligophosphoric acid, polyphosphoric acid, metaphosphoric acid, trimetaphosphoric acid, polymetaphosphonic acid, and the like.

Other protonic acid dopants are organic acids, such as substituted and unsubstituted aryl, heteroaryl, alkyl, or cycloalkyl compounds containing at least one acid functional group selected from the group consisting of sulfonic acid, sulfinic acid, sulfamic acid, sulfanilic acid, sulfuric acid, hydrogen sulfate, bisulfate, carboxylic acid, phosphonic acid, phosphinic acid, phosphoric acid, hydrogen phosphate, dihydrogen phosphate, phosphonous acid, phosphonamidic acid, boric acid, and amino acid. Preferred organic acid dopants are substituted and unsubstituted aryl, heteroaryl, or alkyl compounds containing at least one acid functional group selected from the group consisting of sulfonic acid, sulfinic acid, sulfamic acid, sulfanilic acid, sulfuric acid, hydrogen sulfate, bisulfate, carboxylic acid, phosphonic acid, phosphinic acid, phosphoric acid, hydrogen phosphate, and dihydrogen phosphate.

Yet, other useful acid dopants are polymeric acids. Useful polymeric acid dopants can be organic and inorganic oligomers and polymers being substituted with more than one acid functional groups selected from the group consisting of sulfonic acid, sulfinic acid, sulfamic acid, sulfanilic acid, sulfuric acid, hydrogen sulfate, bisulfate, carboxylic acids, carbonic acid, phosphonic acid, phosphinic acid, phosphoric acid, hydrogen phosphate, dihydrogen phosphate, phosphonous acid, phosphonamidic acid, boric acid, and amino acid. Illustrative useful polymeric acid dopants include substituted and unsubstituted polystyrenesulfonic acids, polyacrylic acids, polymethacrylic acids, polymaleic acids, polyvinylsulfonic acids, sulfonated polystyrenes, sulfonated poly(vinyl naphthalene)s, sulfonated poly(vinyl arene)s, sulfonated poly(vinyl heteroarene)s, sulfonated copolymers or terpolymers comprising at least one aromatic functional group or one heteroaromatic functional group or one styrene repeat units, oligophosphoric acids, polyphosphoric acids, oligometaphosphoric acids, polymetaphosphoric acids, poly(ethylene phosphate)s, poly(propylene phosphate)s, and combination mixtures, copolymers and terpolymers thereof.

The preferred polymeric acid dopants are substituted and unsubstituted polystyrenesulfonic acids, polyvinylsulfonic acids, sulfonated-polystyrenes, sulfonated copolymers or terpolymers that comprise at least one aromatic functional group or one heteroaromatic functional group or one styrene repeat unit, polyphosphoric acids, poly(ethylene phosphate)s, and poly(propylene phosphate)s, and combination mixtures, copolymers and terpolymers thereof.

The acid dopants may be derived completely or partly from the acid catalyst; they can also be derived completely or partly from the latent dopant precursors, such as from the salt, ester, and anhydride forms of any desirable acid dopants. Alternatively, some of the acid dopants may be derived directly or indirectly from the reaction byproducts of the compounds of formula (1) and/or (2). For one embodiment of this invention, the acid dopants may be derived from the leftover acid catalyst used to initiate the polymerization. For another embodiment of this invention, the acid dopants may be the combination of the acid catalyst and the acidic byproducts produced directly or indirectly from the polymerizations or coupling reactions of formula (1) and/or (2). Yet another embodiment may involve the use of latent dopant precursors, which are converted completely or partly into the final acid dopants by the reaction with the acid catalyst and/or with the byproducts produced directly or indirectly from the polymerizations or coupling reactions of formula (1) and/or (2). Alternatively, the convention of the latent dopant precursors into the final acid dopants can also be conducted by thermal treatments (such as by heating) or photochemical treatments (such as by exposing with photon or Laser) or electrochemical treatments during or after the polymerization of formula (1) and/or (2). Yet another interesting embodiment may involve an ultimate dopant system that can be derived from the combination of an organic or inorganic acid catalyst, plus some thermally convertible or chemically convertible or photo-chemically convertible or electrochemically convertible latent dopant precursors of one or more polymeric acid(s), and plus some of the acidic reaction byproduct(s) generated directly or indirectly from the polymerization and/or coupling reactions of the compounds of formula (1) and/or (2). Actually, any combination of the types, forms, original sources and/or production methods of the acid dopants may be used as needed or as desired.

In the cases of highly electron-rich polyheteroaromatic systems, poly(ethylene-3,4-dioxythiophene) (PEDOT), air can even work as an effective oxidant and/or dopant.

### <Doping degree and conductivity>

The amount of dopant added to the conjugated backbone homopolymer or copolymer is not critical and may vary widely. In general, sufficient dopant is added to the homopolymer or copolymer to at least form doped polymer that is a semi-conductor, which has a conductivity of at least about 10⁻¹² ohm⁻¹cm⁻¹. The upper level of conductivity is not critical and depends on the type of homopolymer or copolymer employed. In general, for those applications utilizing the conductivity property, the highest level of conductivity obtained is provided without unduly adversely affecting the environmental stability of the conjugated backbone homopolymer or copolymer. In the various embodiments of the present invention, the amount of dopant employed is sufficient to provide a conductivity of at least about 10⁻⁹ ohm⁻¹cm⁻¹. In particularly preferred embodiments according to the present invention, the amount of dopant is sufficient to provide a conductivity of about 10⁻² ohm⁻¹cm⁻¹ to about 10¹³ ohm⁻¹cm⁻¹.

### <Potential applications>

The polyheteroaromatic prepared according to the present invention can be used for any purpose. For example, they can be used in the fabrication of articles that comprise electrically conductive portions and electrically non-conductive portions, and articles that are completely electrically conductive. Examples of useful applications include electrically conductive polymer housings for EMI shielding of sensitive electronic equipment such as microprocessors; infrared, radio frequency and microwave absorbing shields; flexible electrical conducting connectors; conductive bearings and brushes; semiconducting photoconductor junctions; electrodes; capacitors; field effect transistors; organic memory devices; solar cell device; photovoltaic cells; super capacitor; secondary battery; sensors; smart cards; nonlinear optical materials; medical applications; artificial muscle; reinforcement materials and/or additives; optically transparent or non-transparent corrosion-preventing coatings for corrodible materials such as steel; antistatic materials and optically transparent or non-transparent coatings for packaging electronic components; antistatic carpet fibers; antistatic waxes for floors in computer rooms; antistatic finishes for CRT screens, aircraft, and auto windows, and the like.

Various other applications involve the use of the electroactive coatings of polyheteroaromatics produced according to the present invention include applications such as conductive plastic gas tanks; solar window coatings; transparent electrical elements for heated windows and heated liquid crystal displays; electrochromic displays, electrical contacts for electroluminescent displays and electroluminescent lights, and electrical contacts for piezoelectric films for transparent loud speakers; transparent conducting coatings for windows in burglar alarm systems; membrane coatings for chemical separations (such as O₂ and N₂, for example), and conducting coatings for membrane switches, and a discharge layer or photoresist layer for lithographic process.

Applications involving use of the electroactive coating comprising a conjugated heteroaromatic polymer produced according to this invention include applications such as capacitors, supercapcitors, secondary batteries, antistatic objects such as antistatic textiles, antistatic packaging and buffering materials (e.g., antistatic foams, wraps, bags, trays, cases, boxes, and the like), DSSC and PV solar cells, LED, electroactive coatings for membrane switches, transparent electroactive coating layer for touch screens, electroactive coating layer for touch panels, electroactive coatings for flexible electronic devices, electroactive coating for capacitor microphones, via hole conductive coating for circuitry board, and a discharge layer or photoresist layer for a lithographic process.

The composition of this invention is particularly useful for conductive ink applications. The used polymerization retardant can help suppress the polymerization of the electroactive monomers in the ink formula before the printing, so that the flowing ability of the ink can be maintained. While the use of a soluble polymer binders can render the ink formula with a suitable viscosity for printing. The polymerization can be initiated after printing by performing at least one of a step of raising the temperature of the substrate, a step of evaporating partly the solvent in the composition, and a step of evaporating partly or completely the polymerization retardant used as the functional additive in the composition. Alternatively, the conductive ink formula can utilize the electroactive solution pre-prepared from the composition of this invention, as long as the electroactive polymers can be maintained in the soluble or dispersible forms by the help of a suitable functional additive used in the composition, such as an emulsifier, a polymer binder, a surfactant, and/or a dispersion stabilizer. Likewise, the composition of this invention and/or the electroactive solution prepared therefrom is particularly useful for large area printing or coating applications. The added polymer binder also help enhance the mechanical strengths of the electroactive coatings of this invention, making them even more suitable for the applications of various displays and electrochromic window devices (that require long term durability and high thermal stability), such as electrochromic displays, electroluminescent displays, and liquid crystal displays, solar window, smart windows, electrochromic sunroof, electrochromic windows, electrochromic liquid crystal windows, touch panels, and touch screens.

The electroactive coatings with much improved mechanical strength and thermal stability are also particularly useful for the various electroactive objects (such as antistatic, electrostatic dissipation, EMI shielding, infrared, radio frequency and microwave absorbing shields, and smart cards), electronic devices (such as LED, field effect transistors, organic memory devices, solar cell device, photovoltaic cells, supercapacitors, secondary batteries, and sensors), and flexible electronic articles (such as flexible electronic membranes, contacts, wires, electrodes, connectors, and devices). In one particular embodiment of this invention, the flexible electronic articles can be prepared by forming an electroactive coating, using the composition of this invention, on the substrate of the fibers, fiber bundles, strings, sheets, textiles, waven and/or nonwaven fabrics of synthetic and/or natural polymers.

Furthermore, the composition of this invention is particularly useful for making high quality solid capacitors with much superior performances, such as high static capacitance (with a very high capacitance withdrawing rate, 97±2%, which is the percentage of withdrawable static capacitance vs. the full theoretical static capacitance for the given anode foil in a given capacitor product), low ESR (equivalent series resistance), low DF (dissipation factor), high thermal stability (≥ 240 °C), high mechanical strength, long shelf lifetime (> 2000 hr at 125°C) and service lifetime (>> 7500 h at 125 °C), and small size. The polymerization retardant used in the composition of this invention can retard the polymerization activity until all the pores of a capacitor element has been fully filled with the composition, so that the percentage of pore-filling (and thus the percentage of surface-coverage) of the dielectric layer by the electroactive electrolyte can be greatly boosted up to achieve a much higher static capacitance, and meanwhile having a lower ESR and DF values. The simultaneous use of polymerization retardant and polymer binder as the functional additives can further increase the static capacitance withdrawing rate up to >90-95% of the theoretical values (with the need of only one time coating operation), which are much higher than the achievable capacitance withdrawing rate (in general, ~40-60% of the theoretical values) for a solid capacitor prepared by the conventional method. The much higher percentage of pore-filling plus the use of polymer binder can further enhance the mechanical strengths and thermal stability of the solid capacitor fabricated in this invention, so that they can survive under extreme working environments, such as having high mechanical stresses (caused by the constant vibrational and mechanical motions as encountered in the applications of automobile electrical and electronic equipment and audio-video appliance) and having high working temperatures (caused either by the outdoor solar radiation heat or by the interior heat dissipated or exhausted from the application devices). Thus, the solid capacitors fabricated from the composition and/or the method of this invention are particularly suitable for the applications of automobile electrical and electronic equipment, audio-video appliance, the inverters and/or converters for solar cells and photovoltaic cells, computer servers, LED lighting systems, smart phone, power generators, and power supplies. Whereas, the solid capacitors fabricated by the conventional methods and formulas are in general suffering low percentage of pore-filling (-40-60%) and thus having a very poor mechanical strengths associated with the electroactive-polymer-coated dielectric layer and especially for the dielectric pores that are either non-filled or only partly filled. The constant vibrational and mechanical motions generated by the operations of automobile and AV appliances would create a great deal of micro-cracks, in relative short period of service time, on the non-filled or partly filled area of the dielectric layer, resulting in much increased LC (leakage current) and eventually leading to a short-circuit damage of the solid capacitor. Since the micro-cracks appeared in the non-filled or partly filled pores of the dielectric layer (where are also the most fragile and easily damaged locations) are not readily reachable by the immobile solid electrolyte, thus their constantly appeared micro-cracks cannot be readily and efficiently repaired electrochemically. Hence, the conventional pure solid capacitors are not suitable for such applications. Therefore, currently only the hybrid capacitor having a combination of solid electrolyte coating (for providing a better conductive electrolyte to render the capacitor with a relatively lower ESR) and a liquid electrolyte (for filling the pores that are either non-filled or partly filled by the solid electrolyte to render the capacitor with repairing ability in those most fragile areas) can be used for such applications.

Interestingly, the pure solid capacitors prepared from the composition and method of this invention are essentially free of non-filled or partly filled areas (i.e., with a pore-filling percentage of 95-100%), they are essentially free of fragile areas. Furthermore, the much improved mechanical strength of the solid electrolyte itself in combination with the much enhanced interfacial adhesions between the solid electrolyte and all the surfaces of other material layers of the capacitor element (including anode dielectric layer, the separators, and the cathode foil) render the resultant capacitors as a whole solid pieces of device. Thus, the pure solid capacitors prepared from this invention can easily withstand the vibrational stresses and mechanical impacts, keeping the damage degree of the dielectric layer always very low during their service life. These limited damage defects are all reachable and repairable by the solid electrolyte and can be readily and facilely repaired electrochemically, without the need of using additional liquid electrolyte. Thus, the pure solid capacitors of this invention are particularly workable for the applications having constant vibrational stresses and mechanical impacts, such as automobile electrical and electronic equipment and audio-video appliance. In addition, owing to the combined advantages and controllability provided by the functional components of both polymerization retardant and polymer binder, the compositions and/or the electroactive solutions of this invention are particular suitable for the preparation of capacitors of various types (such as radial-, dip-, SMD-, stacked-, H-chip-, V-chip-, chip-, and hybrid-type capacitors) based on various valve-metal (such as Ta-, Nb-, and Al-based) systems. The much higher capacitance withdrawing rate also enables the solid capacitors of this invention to be made in a much reduced size as compared with the conventional solid capacitors of the same given rated-capacity. Thus, this invention is particularly useful in making chip-type (including stacked-type, H-chip-type, V-chip-type) solid capacitors with a desirable high capacity and meanwhile having a very low profile (i.e., thickness), rendering them even more suitable for the applications in the devices (such as smart phones) of very thin profiles (i.e., thickness).

Another important advantage provided by this invention is a great cost-saving on the production for the solid electrolytic capacitors, especially for the chip type solid capacitors, such as the stacked Al chip type, the Al H-chip (horizontal-chip) type, and the Ta chip type. The convention method for manufacturing the chip type capacitors requires to perform multiple cycles (greater than 5 cycles) of solution-coating treatments with the dispersion solution of PEDOT (as illustrated in US9,728,338B2, US2016/0351340A1 and US9,287,053B2), or with multiple cycles (≥ 10 cycles) of polymerization-coating treatments (each cycle contains four treatment steps: (1) dipping oxidant solution, (2) dipping monomer solution, (3) performing polymerization, and (4) washing away the byproducts) (as illustrated in US6,249,424B1 and US6,421,227B2), or even with the combination of multiple cycles of polymerization-coating treatments plus multiple cycles of solution-coating treatments with PEDOT dispersion solution (as illustrated in US9,761,347B2). Whereas, the production of the chip type solid capacitors with the composition of this invention only requires the use of one-coating-treatment process (when dipping, soaking, and/or impregnation coating methods are employed) or two-coating-treatment (one for each sides) process (when other coating methods are used, such as solution casting, dropping, dripping on, squirting, spraying, doctor blade coating, roller coating, rotogravure printing, sponge roller coating, spin-coating, painting, and printing). The much simplified manufacturing process of this invention is not only energy-saving but also environmental friendly due to the much reduction on chemical waste.

Since the polymerization method of this invention provide a very clean polymer solution (i.e., free of undesirable impurities and byproducts), the resultant polymerization solution obtained after the polymerization process can be directly applied to prepare an electroactive coating. Alternatively, the electroactive coating and/or solutions can be prepared by an *in-situ* polymerization process from the mixture solution containing the monomer and the acid catalyst. In a preferred embodiment of this invention, the electroactive coating or solution is performed by using the composition of this invention that comprises a monomer, an acid catalyst, and at least one functional component selected from the group consisting of a solvent, a polymerization retardant, a polymer binder, a dopant, a latent dopant, a dielectric layer protection agent, a dielectric layer repair agent, a plasticizer, an impact modifier, a reinforcing filler, a blowing agent, a crosslinking agent, an ultraviolet stabilizer, a flame retardant, a photoresist, a thickening agent, a defoaming agent, an emulsifier, a surfactant, and a dispersion stabilizer. In a more preferred embodiment, the at least one functional component contains at least one polymerization retardant so that the polymerization activity of the composition of this invention can be controlled as desired. In a further preferred embodiment, the at least one functional component contains at least one polymerization retardant and one polymer binder so that both the polymerization behaviors of the composition and the application properties of the resultant products of this invention can be further controlled and optimized as desired.

The following examples are presented to more particularly illustrate the present invention, and should not be construed as being limitations on the scope and spirit of the present invention.

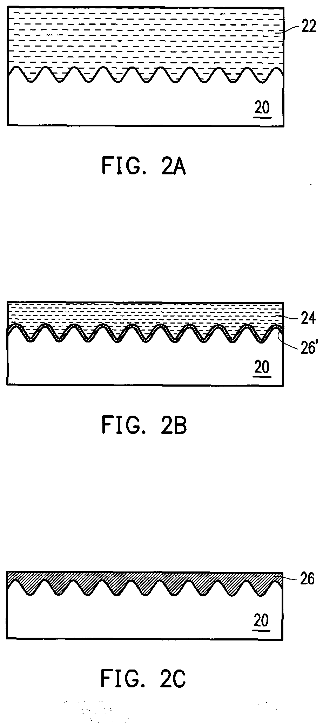

For example, FIGs. 2A-2C illustrate, in a cross-sectional view, an application of the method of this invention wherein the *in-situ* polymerization of at least one compound of formula (1) or (2) is performed over a surface of a substrate to form an organic conductive film.

Referring to FIG. 2A, a solution 22 of a compound of formula (1) and/or (2) with Z=H and Y≠H at a desirable low concentration together with an appropriate amount of acid catalyst in a proper solvent or cosolvent mixture is applied to a substrate 20 at a desirable low temperature so that the polymerization activity is limited. The substrate 20 may be any substrate requiring a surface conductive coating, such as a substrate of an electrode, a solar cell, a window, a panel, a screen, a corrodible material, an electroactive object, a circuitry board, a textile, a fiber, a plastic, a paper, a nonwoven pad, a flexible glass, a ceramic, an epoxy board, a LED or an antistatic object. Particularly, the substrate 20 may be a porous substrate used for fabricating a capacitor, as illustrated in the figure.

Referring to FIG. 2B, a polymerization reaction of this invention is performed and/or initiated on the substrate 20 to form an organic conductive polymer solution or film on the substrate 20 by either raising the temperature of the substrate 20 or evaporating partly or fully the solvent to facilitate the polymerization. For example, as shown in the figure, the solvent is partly removed through evaporation to yield a more concentrated monomer solution to initiate the polymerization, resulting in a concentrated solution 24 of the conductive polymer on the substrate, wherein a thin layer 26' of the conductive polymer in the form of precipitates may be deposited on the surface of the substrate 20. In some case, although some polymerization might have been started in the premixing stage to yield some oligomers or lower molecular weight polymers in the casting solution, the oligomer or polymer molecules can undergo continuous polymerization effectively when the solution becomes more concentrated in the later solvent-evaporation stage, leading to higher molecular weight polymers and resulting in a polymer coating with greater mechanical strength and higher conductivity.

Referring to FIG. 2C, the remaining solvent is fully removed from the concentrated solution 24 of the organic conductive polymer, leaving an organic conductive polymer film 26 on the substrate 20.

In a preferred embodiment, the electroactive polymer solutions or surface coatings are prepared using the composition of this invention.

### <Composition for Forming Electroactive Polymer Solution or Coating>

The composition for forming a conjugated heteroaromatic polymer solution or coating of this invention comprises the aforementioned at least one compound of formula (1) as a monomer that comprises at least one compound of formula (1) with Z=H and Y≠H or the aforementioned at least one compound of formula (2) as a monomer that comprises at least one compound of formula (2) with Z=H and Y≠H, an acid as a polymerization catalyst selected from the group consisting of a protic acid, a polymeric acid, and a non-transitional Lewis acid, and at least one functional component selected from the group consisting of a solvent, a polymerization retardant, a polymer binder, a dopant, a latent dopant, a dielectric layer protection agent, a dielectric layer repair agent, a plasticizer, an impact modifier, a reinforcing filler, a blowing agent, a crosslinking agent, an ultraviolet stabilizer, a flame retardant, a photoresist, a thickening agent, a defoaming agent, an emulsifier, a surfactant, and a dispersion stabilizer. The at least one functional component contains at least a polymerization retardant and a polymer binder. The polymerization retardant comprises at least one Lewis base having a stronger basicity than the monomer and slows down or inhibits polymerization activity of a mixture solution of the monomer and the acid as the polymerization catalyst. The polymer binder (a) is not a polymerization retardant, or (b) comprises a polymeric acid functioning as the acid as the polymerization catalyst and functioning as the dopant. The concentration of the monomer in the composition ranges from 1 wt% to 99 wt%, the molar ratio of the acid as the polymerization catalyst to the monomer ranges from 0.0001 to 20, the molar ratio of the polymerization retardant to the acid as the polymerization catalyst is greater than 0.0001, and the weight ratio of the polymer binder to the monomer ranges from 0.001 to 500.

The at least one compound of formula (1) contained in the composition may consist of a single compound of formula (1) with Z=H and Y≠H, or may include a combination of two or more compounds of formula (1) including at least one compound of formula (1) with Z=H and Y≠H, as mentioned in the above embodiments. The at least one compound of formula (2) contained in the composition may consist of a single compound of formula (2) with Z=H and Y≠H, or may include a combination of two or more compounds of formula (2) including at least one compound of formula (2) with Z=H and Y≠H, as mentioned in the above embodiments. In some desirable embodiments, the composition may contain compounds of both formula (1) and formula (2), with the proviso that at least one of the compounds of formula (1) or formula (2) has a structure with Z=H and Y≠H.

The acid as the polymerization catalyst and the solvent are as exemplified above.

The polymerization retardant slows down or inhibits the polymerization activity of the mixture solution of the monomer and the acid catalyst of this invention, so that the initiation timing and the rate of polymerization can be better controlled as desired.

The polymerization retardant includes a Lewis base having a stronger basicity than the monomer. In a preferred embodiment, the Lewis base is a compound containing at least one atom having lone pair electrons, wherein the at least one atom having lone pair electrons may be preferably selected from the group consisting of O, N, S and P atoms. Examples of the effective *O*-containing Lewis base include: H₂O; alcohols such as methanol, ethanol, propanol, isopropanol, butanol, isobutanol, *t*-butyl alcohol, pentanol, hexanol, heptanol, octanol, nonanol, decanol, undecanol, dodecanol, cyclopentanol, cyclohexanol, ethylene glycol, and so on; ketones such as acetone, ethyl methyl ketone, cyclopentanone, cyclohexanone, hexafluoroacetone, acetylacetone, and so on; ethers such as dimethyl ether, ethyl methyl ether, diethyl ether, dipropyl ether, diisopropyl ether, tetrahydrofuran, tetrahydropyran, dioxane, and so on; esters such as methyl acetate, ethyl acetate, methyl propanoate, ethyl propanoate, methyl butanoate, ethyl butanoate, propyl butanoate, methyl pentanoate, ethyl pentanoate, methyl hexanoate, ethyl hexanoate, propyl hexanoate, methyl heptanoate, methyl octanoate,_phenyl acetate, dimethyl terephthalate, dimethyl isophthalate, dimethyl phthalate, tetramethyl benzenetetracarboxylate, trimethyl benzenetricarboxylate, methyl benzoate, phenyl benzoate, and so on; symmetric or asymmetric cyclic and acyclic carbonate esters such as dimethyl carbonate, diethyl carbonate, dipropyl carbonate, dibutyl carbonate, dipentyl carbonate, diphenyl carbonate, ethyl methyl carbonate, ethyl butyl carbonate, methyl phenyl carbonate, benzyl phenyl carbonate, methoxyphenyl nitrophenyl carbonate, ethylene carbonate, propylene carbonate, butylene carbonate, 4-ethyl-1,3-dioxan-2-one, 4-ethyl-6-propyl-1,3-dioxan-2-one, and so on; aldehyde, such as formaldehyde, acetaldehyde, benzaldehyde, and so on; anhydrides, such as acetic anhydride, acetic formic anhydride, benzenetetracarboxylic dianhydride, and so on; orthosilicates, such as tetramethyl orthosilicate, tetraethyl orthosilicate, tetrapropyl orthosilicate, tetrabutyl orthosilicate, tetrapentyl orthosilicate, and so on; alkoxysilanes, such as ethyltrimethoxysilane, diethyldimethoxysilane, triethylmethoxysilane, octyltrimethoxysilane, octyltriethoxysilane, dodecyltrimethoxysilane, and so on; siloxanes such as hexamethyldisiloxane, hexamethylcyclotrisiloxane, and so on; and O-containing polymers such as substituted and unsubstituted polyethers, polyacetals, polyesters, polyketones, polyetherketones, polyetheretherketones, poly(phenylene oxide)s, poly(ethylene oxide)s, poly(propylene oxide)s, poly(ethylene glycol)s, poly(propylene glycol)s, poly(vinyl acetate)s, poly[ethylene-co-(vinyl acetate)]s, polyvinyl alcohols, poly[ethylene-co-(vinyl alcohol)]s, Si-O bond containing polymers, polysilicates, polysiloxanes, polyacrylates, polymethacrylates, and so on.

Examples of the effective *N*-containing Lewis base include: amines, such as methylamine, dimethylamine, trimethylamine, ethylamine, diethylamine, triethylamine, aniline, *N-*methylaniline, *N,N-*dimethylaniline, pyrrolidine, piperidine, morpholine, quinuclidine, 3-pyrroline, and so on; amides, such as 1-methyl-2-pyrrolidinone, 2-pyrrolidinone, *N*,*N*-dimethylformamide, *N,N-*dimethylacetamide, and so on; imides, such as phthalimide, uracil, thymine, cytosine, and so on; nitriles, such as acetonitrile, benzonitrile, and so on; *N-*containing heterocyclic compounds and *N-*containing heteroaromatic compounds, such as imidazole, 2-methylimidazole, pyrazole, triazole, pyridine, pyridazine, pyrazine, indole, quinoline, pyrimidine, purine, adenine, guanine, and so on; *N*-containing polymers, such as substituted and unsubstituted polyamines, polyamides, polyimides, polyetherimides, polyureas, polyurethanes, polyphosphazenes, polyvinylpyridines, polyvinylpyrrolidones, and so on.

Examples of the effective *S*-containing Lewis base include: sulfides, such as dimethyl sulfide, diethyl sulfide, tetrahydrothiophene, tetrahydrothiapyran, and so on; sulfoxides, such as dimethylsulfoxide, tetramethylene sulfoxides, and so on; sulfones, such as dimethylsulfone, tetramethylene sulfone, and so on; sulfites, such as dimethyl sulfite, diethyl sulfite, and so on; sulfates, such as dimethyl sulfate, diethyl sulfate, dipropyl sulfate, dibutyl sulfate, and so on; bisulfates, such as methyl bisulfate, ethyl bisulfate, isopropyl bisulfate, dodecyl bisulfate, and so on; and *S*-containing polymers, such as substituted and unsubstituted poly(phenylene sulfide)s, poly(alkylene sulfide)s, polysulfones, polythioacetals, and polythioketals, etc.

Examples of the effective *P*-containing Lewis base include: phosphines, such as triphenylphosphine, trimethylphosphine, tributylphosphine, tricyclohexylphosphine, di-t-butylphosphine, tris(dimethylamino)phosphine, and so on; phosphine oxides, such as trimethylphosphine oxide, triethylphosphine oxide, tripropylphosphine oxide, tributylphosphine oxide, trihexylphosphine oxide, trioctylphophine oxide, triphenylphosphine oxide, and so on; phosphites such as dimethyl phosphite, di-*t*-butyl phosphite, tributyl phosphite, triphenyl phosphite, tetraethyl pyrophosphite, and so on; phosphonates, such as diethyl ethylphosphonate, diphenyl benzylphosphonate, and so on; phosphates, such as trimethylphosphate, triethylphosphate, tripropylphosphate, tributylphosphate, trihexyl phosphate, trioctylphosphate, triphenylphosphate, and so on; phosphoramides, such as hexamethylphosphoramide and hexaethylphosphoramide, and so on; and *P*-containing polymers, such as substituted and unsubstituted polyphosphazenes, poly(ethylene phosphate)s, poly(propylene phosphate)s, and so on.

### <Polymer binders>

Any polymer binders can help increase the viscosity of the composition, or enhance the mechanical strength of the resultant solid polymer electrolyte, or increase the thermal stability of the resultant solid polymer electrolyte, or help improve the electric current transportation morphology of final solid polymer matrix, or help strengthen the interfacial adhesion between the solid electrolyte and the anode foil, cathode foil, and the separators, or even help improve the solubility and/or dispersion ability of the solid electrolyte in the desirable electroactive solution. Furthermore, some of the polymer binders can serve for more than one function. For example, some desirable polymeric acids can serve as the acid catalyst, the polymer binder, and the final acid dopant, such as substituted and unsubstituted poly(glycolic acid)s, poly(lactic acid)s, polystyrenesulfonic acids, polyacrylic acids, polymethacrylic acids, polymaleic acids, polyvinylsulfonic acids, sulfonated polystyrenes, sulfonated poly(vinyl naphthalene)s, sulfonated poly(vinyl arene)s, sulfonated poly(vinyl heteroarene)s, sulfonated copolymers or terpolymers comprising at least one aromatic functional group or one heteroaromatic functional group or one styrene repeat unit, oligophosphoric acids, polyphosphoric acids, oligometaphosphoric acids, polymetaphosphoric acids, poly(ethylene phosphate)s, poly(propylene phosphate)s, and the combination mixtures, copolymers, terpolymers, and polymers thereof.

In another embodiment, some polymer can serve as the polymerization retardant and polymer binder, such as *O*-containing polymers like substituted and unsubstituted polyethers, polyacetals, polyesters, polyketones, polyetherketones, polyetheretherketones, poly(phenylene oxide)s, poly(ethylene oxide)s, poly(propylene oxide)s, poly(ethylene glycol)s, poly(propylene glycol)s, poly(vinyl acetate)s, poly[ethylene-co-(vinyl acetate)]s, polyvinylalcohols, poly[ethylene-co-(vinyl alcohol)]s, Si-O bond containing polymers, polysilicates, polysiloxanes, polyacrylates, and polymethacrylates; or *N*-containing polymers, such as substituted and unsubstituted polyamines, polyamides, polyimides, polyetherimides, polyureas, polyurethanes, and polyphosphazenes, polyvinylpyridines, polyvinylpyrrolidones; or *S*-containing polymers, such as substituted and unsubstituted poly(phenylene sulfide)s, poly(alkylene sulfide)s, polysulfones, polythioacetals, and polythioketals, or *P*-containing polymers, such as substituted and unsubstituted polyphosphazenes, poly(ethylene phosphate)s, poly(propylene phosphate)s.

Any natural or synthetic homopolymers, copolymers, or polymer mixtures can be used as the polymer binder as long as it is soluble or dispersible in the composition. Useful polymer binders include thermosetting plastics and thermoplastic plastics. When thermosetting plastics are used, the polymer binders are prepared in-situ, during the polymerization of the conjugated polyheteroaromatic polymers, from a soluble monomer, oligomer, or polymer precursor plus a crosslinking or coupling reagent. The_preferred polymer binders are substituted and unsubstituted thermoplastic homopolymers, copolymers, terpolymers, or polymer mixtures. Illustrative useful thermoplastic polymers include substituted and unsubstituted polyethylenes, polypropylenes, polyolefins, poly(α-olefin)s, polyalkenes, polypentenamer, polyoctenamers, polycaprolactones, nylons, polycaprolactams, polyamides, polyamines, polyphosphazenes, polyesters, PET, poly(butylene terephthalate)s, poly(trimethylene terephthalate)s, poly(glycolic acid)s, poly(lactic acid)s, poly(4-hydroxybenzoate)s, polyacrylates, polymethacrylates, polyacrylamides, polyacrylonitriles, poly(trialkylsilyl methacrylate)s, polystyrenes, poly(styrenesulfonic acid)s, poly(styrene sulfonate)s, poly(alkyl styrenesulfonate)s, polyphosphoric acids, poly(ethylene phosphate)s, poly(propylene phosphate)s, PS-PMMA copolymers, PMMA, polybutadienes, polychloroprenes, polyisoprenes, natural rubbers, cellulose, nitrocellulose, cellulose ether, regenerated cellulose, hemicelluloses, polysaccharides, lignin, shellac, starch, asphaltenes, bitumens, polypeptides, proteins, regenerated proteins, collagen, polyisobutylenes, polysiloxanes, polyureas, polyurethanes, styrene-butadiene rubbers, EPDM, acrylonitrile-butadiene rubbers, ABS, isobutylene-isoprene rubbers, polyethers, poly(ethylene glycol)s, poly(ethylene oxide)s, poly(propylene glycol)s, poly(propylene oxide)s, poly (hexafluoropropylene oxide)s, poly[3,3-(dichloromethyl)trimethylene oxide]s, polytetrahydrofurans, poly(alkylene polysulfide)s, poly(methyl vinyl ketone)s, polyketones, polyetheretherketones, polyetherimides, polyimides, polysulfones, polycarbonates, polyamideimides, polyarylates, polybenzimidazoles, poly(phenylene oxide)s, poly(phenylene sulfide)s, poly(p-xylylene)s, polyacetals, polyformaldehydes, polyketals, polyacetones, polyvinylpyrrolidones, polyvinylpyridines, poly(vinyl chloride)s, poly(vinylidene chloride)s, poly(vinylidene fluoride)s, poly(vinyl acetate)s, poly(vinyl alcohol)s, poly[ethylene-co-(vinyl acetate)]s, poly[ethylene-co-(vinyl alcohol)]s, and combination polymer mixtures, copolymers or terpolymers thereof.

The more preferred polymer binder is selected from substituted and unsubstituted polyacrylates, polymethacrylates, polyacrylamides, polyacrylonitriles, polystyrenes, PMMA, PS-PMMA copolymers, poly(styrenesulfonic acid)s, poly(styrene sulfonate)s, poly(alkyl styrenesulfonate)s, polyphosphoric acids, poly(ethylene phosphate)s, poly(propylene phosphate)s, nylons, polycaprolactams, polyamides, polyvinylpyrrolidones, polyvinylpyridines, polyphosphazenes, polyesters, PET, polycaprolactones, polybutadienes, polychloroprenes, polyisoprenes, natural rubbers, polyisobutylenes, styrene-butadiene rubbers, EPDM, acrylonitrile-butadiene rubbers, ABS, isobutylene-isoprene rubbers, polyethers, poly(ethylene glycol)s, poly(ethylene oxide)s, poly(propylene glycol)s, poly(propylene oxide)s, polytetrahydrofurans, polysiloxanes, poly(methyl vinyl ketone)s, polyketones, polyetheretherketones, polyetherimides, polyimides, polyamideimides, polybenzimidazoles, polyureas, polyurethanes, polycarbonates, polyarylates, poly(p-xylylene)s, poly(phenylene oxide)s, poly(phenylene sulfide)s, polysulfones, polyacetals, polyformaldehydes, polyketals, polyacetones, poly(vinylidene fluoride)s, poly(vinyl acetate)s, poly(vinyl alcohol)s, poly[ethylene-co-(vinyl acetate)]s, poly[ethylene-co-(vinyl alcohol)]s, and the combination copolymers, terpolymers, or polymer mixtures thereof.

The concentration of the monomer in the composition ranges from 1 wt% to about 99 wt%, preferably from 10 wt% to about 99 wt%. The molar ratio of the acid as the polymerization catalyst to the monomer ranges from 0.0001 to 20, preferably from 0.001 to 5. The molar ratio of the polymerization retardant to the acid catalyst ranges widely (without upper limit) to be at least greater than 0.0001, preferably greater than 0.01, and more preferably greater than 0.1. The weight amount of polymer binder vs. the weight amount of the monomer ranges from 0.001 to 500, preferably from 0.01 to 250, and more preferably from 0.1 to 100.

### <Method for Forming Electroactive Polymer Solution>

The method for forming an electroactive polymer solution as described herein includes: placing the above composition in a reactor, and conducting at least one of a step of raising the temperature of the composition, a step of evaporating partly the solvent in the composition, and a step of evaporating partly or completely the polymerization retardant used as the functional component in the composition, so as to initiate and/or continue polymerization to form an electroactive polymer solution comprising a conjugated heteroaromatic polymer.

### <Method for Forming Electroactive Coating>

The method for forming an electroactive coating of this invention includes: a) contacting the above composition with a surface of a substrate, and b) conducting at least one of a step of raising the temperature of the substrate, a step of evaporating partly the solvent in the composition, and a step of evaporating partly or completely the polymerization retardant used as the functional additive in the composition, so as to induce and/or continue the polymerization on the surface of the substrate and form an electroactive coating comprising a conjugated heteroaromatic polymer.

The substrate may include a porous substrate used for fabricating a capacitor, corresponding to the above substrate 20 (FIGs. 2A to 2C) that can also be a substrate of an electrode, a solar cell, a window, a panel, a screen; or a corrodible material, an electroactive object, a circuitry board, a textile, a fiber, a plastic, a paper, a nonwoven pad, a flexible glass, a ceramic, an epoxy board, a LED or an antistatic object. The porous substrate may be a porous anode electrode of a capacitor element having a desirable dielectric surface layer formed by anodization.

The raised temperature may be within the range of 30 to 200°C.

In addition, by including an effective polymerization retardant as a functional component, such as a Lewis base, having a stronger basicity than the monomer, the stability of the composition for forming an electroactive coating of this invention can be greatly enhanced, which will allow the use of a composition having a much higher monomer concentration so that a conductive polymer coating having a sufficient thickness may be formed in a single cycle of the above steps a) and b). Nevertheless, if required, it is also possible to repeat the steps a) and b) for at least one cycle.

An example where the at least one functional component includes at least a polymerization retardant is described below, also being illustrated by FIGs. 2A to 2C.

Referring to FIG. 2A, a solution 22 of a compound of formula (1) or (2) with Z=H and Y≠H or a neat liquid of the compound is applied to a substrate 20. Because of the presence of the polymerization retardant, the solution 22 is allowed to use a desirable higher concentration of the compound, or even a neat liquid of the compound. The solution 22 may also or alternatively contain shorter polymer formed previously with the method of this invention. The substrate 20 may be any one mentioned above.

Referring to FIG. 2B, a polymerization reaction of this invention is initiated and/or continued (when the solution contains shorter polymer formed previously with the method of this invention) by conducting at least one of a step of raising a temperature of the substrate 20, a step of evaporating partly the solvent in the composition, and a step of evaporating partly or completely the polymerization retardant in the composition, so as to form an electroactive solution or film 24 on the substrate 20. A thin layer 26' of the conductive polymer in the form of precipitates may be deposited on the surface of the substrate 20. It is also possible that the preformed oligomer or polymer molecules can undergo continuous polymerization effectively, leading to higher molecular weight polymers and eventually resulting in an electroactive polymer coating with greater mechanical strength and higher conductivity.

Referring to FIG. 2C, the remaining solvent is then fully removed as in the above example, leaving an electroactive polymer film 26 on the substrate 20.

### <Method for Fabricating Solid Electrolytic Capacitor>

The method for fabricating a solid electrolytic capacitor of this invention includes: forming an anode, forming a dielectric layer on the anode, and then forming a conjugated heteroaromatic polymer coating as a solid electrolyte on the dielectric layer with the above methods for forming a conjugated heteroaromatic polymer coating.

The anode may be formed from a valve metal composition. The valve metal composition may contain a valve metal (i.e., a metal that can be oxidized) or a valve metal-based compound, such as tantalum, niobium, aluminum, hafnium, titanium, alloys thereof, oxides thereof, nitrides thereof, and so on. Examples of the anode formed from valve metal oxides may include niobium oxide (e.g., NbO), tantalum oxide, etc.

The dielectric layer may be formed on the anode by anodizing the surface of the anode. Anodization is an electrical chemical process by which the metal of the anode is oxidized to form a material having a relatively high dielectric constant. For example, the surface of a tantalum anode may be anodized to form tantalum oxide (Ta₂O₅) surface layer, which has a dielectric constant "k" of about 27. For another example, the aluminum anode may be anodized to form an aluminum oxide (Al₂O₃) surface layer, which has a dielectric constant "k" of about 7 to 10.

To conduct anodization, the anode (e.g., Al metal foil) may be dipped into a weak acid solution at an elevated temperature that is supplied with a controlled amount of voltage and current to form a dielectric (e.g., Al₂O₃) surface layer having a certain thickness. The power supply may be initially kept at a constant current until the required formation voltage is reached. Thereafter, the power supply is kept at a constant voltage to ensure that the desired dielectric quality is formed over the surface of the anode (e.g., aluminum anode). The anodization voltage typically ranges from about 5 to about 700 volts.

Nevertheless, it is well known in the art that that the dielectric layer on the anode may be formed from other types of materials and using different techniques.

### [EXAMPLES]

The following examples are intended to further explain this invention, but are not intended to limit the scope of this invention.

### Examples 1-4. Effects of functional components of polymerization retardant and polymer binder

An anode aluminum foil having an Al₂O₃ dielectric layer formed at an electrochemical forming voltage of 9 V and a cathode aluminum foil of high surface area prepared by an electrochemical erosion were wounded together with an interposed separator to form a solid electrolytic capacitor element, as conventionally designed for a capacitor with a rated voltage of 6.3 V and a rated capacitance of 470 µF. After the electrochemical reforming treatment in an organic acid solution to repair the damaged dielectric layer, the capacitor element was dipped for 10 minutes in a composition solution containing 2-bromo-3,4-ethylenedioxythiophene (BEDOT) as the monomer (1 M) and toluenesulfonic acid (TsOH) as the acid catalyst (0.05 equiv) together with or without the addition of optional functional component(s), such as polymerization retardant (e.g., ethyl acetate; EA; 1 equiv) and/or polymer binder (e.g., polystyrene; PS; 0.1 equiv). Then, the polymerization was performed by heating the dipped capacitor element at the elevated temperatures ranging from 60 °C to 190 °C for 30 min to drive the polymerization to completion. The static capacitance (C; at 120 Hz), the equivalent series resistance (ESR; at 100 kHz) and the dissipation factor (DF; at 120 Hz) was measured and summarized in Table 1.

### Comparative Example A:

A wounded aluminum capacitor, as prepared by the same method in Examples 1-4, was dipped with a monomer solution of 3,4-ethylenedioxythiophene (EDOT; 30 wt%) and then with an oxidant solution of iron(III) tosylate (Fe(OTs)₃; 30 wt%; 2.5 equiv) for 10 minutes, respectively. Then, the polymerization was performed by heating the dipped capacitor element at the elevated temperatures ranging from 60 °C to 190 °C for 30 min to drive the polymerization to completion. The static capacitance (C; at 120 Hz), the equivalent series resistance (ESR; at 100 kHz) and the dissipation factor (DF; at 120 Hz) was measured and summarized in Table 1.

**Table 1. Effect of the addition of functional components**

| Example | Functional component(s) used | | C (µF) (at 120 Hz) | ESR (mΩ) (at 100 KHz) | DF (at 120 Hz) |
|---|---|---|---|---|---|
| | Polymerization retardant | Polymer Binder | | | |
| 1 | No | No | 533 | 10 | 0.021 |
| 2 | No | Yes | 525 | 12 | 0.050 |
| 3 | Yes | No | 570 | 12 | 0.038 |
| 4 | Yes | Yes | 607 | 6 | 0.016 |
| Comparative A | EDOT/Fe(OTs)₃ | | 412 | 15 | 0.058 |

| | | | | | |
|---|---|---|---|---|---|
| C: static capacitor measured at 120 Hz; ESR: equivalent series resistance measured at 100 kHz; DF: dissipation factor measured at 120 Hz. | | | | | |

The results summarized in Table 1 clearly demonstrated that the solid capacitors prepared by the new cationic chain-growth polymerization method of this invention (Examples 1-4) all give much higher static capacitance (525-607 µF) than the solid capacitor prepared by the conventional oxidative polymerization method (Comparative Example A; 412 µF). Regarding to the experiments of Examples 1-4, the capacitor prepared from the composition containing no polymerization retardant and no polymer binder gave a relatively lower static capacitance (533 µF). Adding a polymerization retardant (as in Example 3) did help to give an effective increment on the static capacitance (570 µF); while addition of a polymer binder along (as in Example 2) did not help to increase the static capacitance (525 µF). Most interestingly, the use of both polymerization retardant and polymer binder (as in Example 4) not only gave the highest static capacitance (607 µF), but also gave the lowest ESR (6 mΩ) and DF value (0.016). The results indicated that the composition and the polymerization method of this invention can render the solid capacitors with much better performance, having much higher capacitance together with lower ESR and DF values.

### Examples 5-8: Thermal stability test at 240°C

The solid capacitors prepared in Examples 1-4 were subjected to a thermal heating experiment in Example 5-8, respectively, at 240 °C for 38 minutes. After cooling down to room temperatures, the properties of the resultant capacitors were measured and listed, respectively, in Example 5-8 (Table 2).

### Comparative Example B:

The solid capacitor prepared in Comparative Example A was subjected to the same thermal heating treatment as in Examples 5-8. The properties of the resultant capacitor were measured and listed in Table 2.

**Table 2: Thermal stability test at 240 °C for 38 minutes**

| Example | Functional component(s) used | | C (µF) (at 120 Hz) | ESR (mΩ) (at 100 KHz) | DF (at 120 Hz) | capacitor performance quality |
|---|---|---|---|---|---|---|
| | polymerizati on retardant | polymer binder | | | | |
| 5 | No | No | 518 | 42 | 0.100 | downgraded |
| 6 | No | Yes | 480 | 22 | 0.060 | downgraded |
| 7 | Yes | No | 564 | 50 | 0.100 | downgraded |
| 8 | Yes | Yes | 607 | 6 | 0.011 | upgraded |
| Comparative B | EDOT/Fe(OTs)₃ | | 774 | 21 | 2.92 | failed in total |

| | | | | | | |
|---|---|---|---|---|---|---|
| C: static capacitor measured at 120 Hz; ESR: equivalent series resistance measured at 100 kHz; DF: dissipation factor measured at 120 Hz. | | | | | | |

The results summarized in Tables 1 and 2 clearly demonstrated that the capacitor prepared by the conventional oxidative polymerization method (as in Comparative Example B) based on the conventional composition (EDOT/Fe(OTs)₃) had failed totally after been heated at 240 °C for 38 minutes, having a DF value (2.92) that had already been much over 0.12, which is the allowable upper limit value of DF for a commercial solid capacitor. All the capacitors prepared by the newly invented cationic chain-growth polymerization method (Examples 5-8) from the composition of the invention (BEDOT plus acid catalyst) had all survived from the thermal treatment at 240 °C for 38 minutes. The results have further indicated that the performance of the capacitors in Examples 5-7 had actually already downgraded to some extents (though still appeared within the acceptable range), showing decreased capacitances together with increased ESR and DF values. Clearly, only the capacitor in Example 8 (with the addition of both polymerization retardant and polymer binder as the functional components) could completely overcome such thermal heating treatment, without suffering any degradation. Actually, the DF value of Example 8 had been unexpectedly and significantly reduced further from 0.016 to 0.011 (note: the lower DF value implies a higher electric power consuming efficiency). The unusual thermal annealing effect associated with this invented capacitor is certainly worth noting. The results herein clearly confirmed that the composition and polymerization method of this invention can render the solid capacitors with much higher thermal stability than the conventional composition and method. The results further indicated that best performance can be achieved when both polymerization retardant and polymer binder are used as the functional components of this invention.

### Examples 9-11. Withstanding or breakdown voltage test I

An anode aluminum foil having an Al₂O₃ dielectric layer formed at an electrochemical forming voltage of 50 V and a cathode aluminum foil of high surface area prepared by an electrochemical erosion were wounded together with an interposed separator to form a solid electrolytic capacitor element, as conventionally designed for a capacitor with a rated voltage of 35 V and a rated capacitance of 220 µF. After the electrochemical reforming treatment in an organic acid solution to repair the damaged dielectric layer, the capacitor element was dipped for 10 minutes in a composition solution containing monomer (BEDOT; 1.5 M) and various acid catalyst (as listed in Table 3; 0.15 equiv) together with the functional components of both polymerization retardant (ether, 2 equiv) and polymer binder (poly[styrene-co-(methyl methacrylate)]; PS-PMMA; 0.2 equiv). Then, the polymerization was performed by heating the dipped capacitor element at the elevated temperatures ranging from 60 °C to 190 °C for 30 min to drive the polymerization to completion. After the preparation, the resultant capacitors were all subjected to aging treatments to reduce their leakage currents to below the value of ~154 µA (i.e., ~0.02CV). The capacitors were then subjected to withstanding or breakdown voltage test, respectively, by raising the applied voltage gradually until the breakdown of the electrolyte had occurred or until 48 V (the voltage slightly below the forming voltage of the anodic Al foil) was reached. The results of the withstanding or breakdown voltage for the respective electrolytes are summarized in Table 3.

### Comparative Example C:

A wounded aluminum capacitor, as prepared by the same method in Examples 8-11, was dipped with a monomer solution of 3,4-ethylenedioxythiophene (EDOT; 30 wt%) and then with an oxidant solution of iron(III) tosylate (Fe(OTs)₃; 30 wt%; 2.5 equiv) for 10 minutes, respectively. Then, the polymerization was performed by heating the dipped capacitor element at the elevated temperatures ranging from 60 °C to 190 °C for 30 min to drive the polymerization to completion. After the preparation, the resultant capacitor was all subjected to aging treatments to reduce its leakage current to ~154 µA. The capacitors were then subjected to the same withstanding or breakdown voltage test, as in Examples 9-11, by raising the applied voltage gradually until the breakdown of the electrolyte. The breakdown voltage is listed in Table 3.

**Table 3: Withstanding or breakdown voltage tests**

| Example | Composition used | Withstanding or breakdown voltage | Status of capacitor |
|---|---|---|---|
| 9 | BEDOT/DBSA | ∼41 V | breakdown |
| 10 | BEDOT/DNNDSA | >48 V | withstanding |
| 11 | BEDOT/PSS | >48 V | withstanding |
| Comparative C | EDOT/Fe(OTs)₃ | <16 V | breakdown |

| | | | |
|---|---|---|---|
| BEDOT: 2-bromo-3,4-ethylenedioxythiophene; EDOT: 3,4-ethylenedioxythiophene; DBSA: dedecylbenzenesulfonic acid; DNNDSA: dinonylnaphthalenedisulfonic acid; PSS: poly(styrenesulfonic acid); Fe(OTs)₃: iron(III) tosylate. | | | |

The results summarized in Table 3 clearly indicated that the solid capacitor containing the conventional solid electrolyte prepared from the conventional composition of EDOT/Fe(OTs)₃ could only withstand at most up to 16 V; while the solid capacitor containing the solid electrolyte prepared from the composition of this invention can withstand the voltage up to ~41 V when the composition of Example 9 (BEDOT/DBSA) was used. The solid capacitors could withstand even higher voltages when the composition of Example 10 (BEDOT/DNNDSA) and Example 11 (BEDOT/PSS) were used. Both capacitors survived even after been forced at a high voltage of 48 V The results indicated that the composition of this invention can render the solid capacitors of this invention with a much higher working voltage than the solid capacitors prepared with the conventional composition (EDOT/Fe(OTs)₃).

### Examples 12-13: Withstanding or breakdown voltage test II

An anode aluminum foil having an Al₂O₃ dielectric layer formed at an electrochemical forming voltage of 149 V and a cathode aluminum foil of high surface area prepared by an electrochemical erosion were wounded together with an interposed separator to form a solid electrolytic capacitor element, as conventionally designed for a capacitor with a rated voltage of 100 V and a rated capacitance of 22 µF. After the electrochemical reforming treatment in an organic acid solution to repair the damaged dielectric layer, the capacitor element was dipped for 10 minutes in a composition solution containing monomer (BEDOT; 1 M) and various acid catalyst (as listed in Table 4; 0.05 equiv) together with the functional components of both polymerization retardant (acetone, 2 equiv) and polymer binder (poly[styrene-co-(methyl acrylate)]; PS-PMA; 0.2 equiv). Then, the polymerization was performed by heating the dipped capacitor element at the elevated temperatures ranging from 60 °C to 190 °C for 30 min to drive the polymerization to completion. After the preparation, the resultant capacitors were all subjected to aging treatments to reduce their leakage currents to below the value of ~44 µA (i.e., ~0.02CV). The capacitors were then subjected to withstanding or breakdown voltage test, respectively, by raising the applied voltage gradually until the breakdown of the electrolyte had occurred or until 145 V (the voltage slightly below the forming voltage of the anodic Al foil) was reached. The results of the withstanding or breakdown voltage for the respective electrolytes are summarized in Table 4.

**Table 4: Withstanding or breakdown voltage tests**

| Example | Composition used | Withstanding or breakdown voltage | Status of capacitor |
|---|---|---|---|
| 12 | BEDOT/DNNDSA | 61V | Breakdown |
| 13 | BEDOT/PSS | 145 V | Withstanding |

| | | | |
|---|---|---|---|
| BEDOT: 2-bromo-3,4-ethylenedioxythiophene; DNNDSA: dinonylnaphthalenedisulfonic acid; PSS: poly(styrenesulfonic acid); | | | |

The results summarized in Table 4 clearly indicated that the solid capacitor containing the solid electrolyte prepared from the composition of this invention can withstand the voltage up to ~61V when the composition of Example 12 (BEDOT/DNNDSA) was used. While a much higher withstand voltage of >145 V could be achieved when the composition of Example 13 (BEDOT/PSS) was used. The results indicated that the composition of this invention can render the solid capacitors with a very high working voltage.

### Example 14: Long term lifetime test at 125°C

A solid capacitor similarly prepared as in Example 4, except that a copolymer of styrene/butadiene was used as the polymer binder, was subjected to a long term thermal heating at 125°C continuously for about 7500 hours. The resultant capacitor was found to show quite similar properties (within the tolerable variation range for a commercial solid capacitor) as the initial capacitor, having a slightly decreased (~2.7%) static capacitance (at 120 Hz; from 528 to 514 µF), a fairly increased equivalent series resistance (at 100 kHz; from 19 to 28 mΩ) and dissipation factor (at 120 Hz; from 0.076 to 0.092). Most interestingly, the leakage current (at 6.3 V) has unexpectedly and significantly decreased from 38 to 17 µA, suggesting that the degradation of this invented solid capacitor during the long term storage at high temperatures essentially follows the safer open-circuit mode. This could be considered as a self-healing capability of the capacitor. The results indicated that the composition of this invention can render the solid capacitors with a very long shelf- and service-lifetime and a suitability for long-term high-temperature application such as for LED lighting bulbs.

### Example 15: Ultrasonication tests

The thermal heated solid capacitor of Example 8 was further subjected to a ultrasonication test. The solid capacitor was mounted on an epoxy board, soaked into a water bath of an ultrasonicator (Branson model 1510; 40 kHz, 80W), and then subjected to ultrasonication continuously for 1 hour. After the ultrasonication treatment, all the performance remained unchanged, with the LC actually slightly decreased (from 76 µA down to 70 µA). This could also be considered as a self-healing capability of the capacitor. For comparison, another conventional solid capacitor prepared similarly as in Comparative Example A was subjected directly, without a prior thermal roasting (to avoid complicated damage effects created by the compounded thermal and mechanical vibration factors), to the same ultrasonication test for 1 hour. The resultant capacitor was found to have a significantly reduced static capacitance (from 405 down to 375 µF) and substantially increased LC (increased from 75 to 214 µA). The results herein indicated that the solid capacitors of this invention are much more suitable than the conventional solid capacitors for high temperature and/or high mechanical stress applications, such as automobile electrical and electronic equipment and audio-video appliance.

### Example 16: Low temperature characteristics

An anode aluminum foil having an Al₂O₃ dielectric layer formed at an electrochemical forming voltage of 41 V (having a theoretical static capacity value of ~350 µF) and a cathode aluminum foil of high surface area prepared by an electrochemical erosion were wounded together with an interposed separator to form a solid electrolytic capacitor element, as conventionally designed for a capacitor with a rated voltage of 25 V and a rated capacitance of 220 µF (that is the maximum achievable static capacity of said capacitor element, using the conventional fabrication method). After the electrochemical reforming treatment in an organic acid solution to repair the damaged dielectric layer, the capacitor element was dip-coated with a similar composition and then was polymerized by a similar process as used in example 9.

The resultant capacitor was found to have a static capacity of 341 uF, a ESR of 18 mΩ, and a DF of 0.024. Such static capacity is actually already 1.55 times higher than the rated capacity 220 µF and have achieved a capacitance withdrawing rate of -97.4%, which is much higher than the capacitance withdrawing rate of ~60% in general associated with the solid capacitors prepared by the conventional composition of EDOT/Fe(III) and the oxidative polymerization method. The results have repeatedly demonstrated the superior pore-filling capability of this invented composition and polymerization method.

The resultant capacitor of this invention was also found to have a superior low temperature characteristic. The performance characteristics were measured at different temperatures (such as 25°C, 0°C, -25°C, -40°C, and -55°C) and summarized in Table 5. The ratios between the values of a specific characteristic property X measured at -55°C to that measured at 25°C are listed in the last column of Table 5. The results indicate that, as the test temperature lowered from 25°C to -55°C, the static capacity showed only a small reduction (~4%) and both ESR and DF also displayed only small increments, with ~12% and -16.7%, respectively. These low temperature characteristic properties are far superior than any current capacitors (including solid, liquid, or hybrid types) prepared by the conventional techniques. The results of this example indicated that the capacitors of this invention can still function properly as they are originally designed for, even under the extreme cold weather conditions as in the polar areas. As shown in Table 5, a reduction of less than 5% in the static capacitance and an increase of less than 20% in the ESR could be achieved at -55°C, as compared to the static capacitance and the ESR at 25°C.

**Table 5. Characteristic properties measured at different temperatures in between 25°C and -55°C.**

| X properties | X(25) | X(0) | X(-25) | X(-40) | X(-55) | X(-55)/X(25) |
|---|---|---|---|---|---|---|
| Cap (µF) | 341.2 | 336.6 | 331.9 | 329.7 | 327.3 | 0.959 |
| ESR (mΩ) | 18.1 | 18.4 | 19.0 | 19.3 | 20.3 | 1.122 |
| DF | 0.024 | 0.023 | 0.025 | 0.026 | 0.028 | 1.167 |

| | | | | | | |
|---|---|---|---|---|---|---|
| C: static capacitor measured at 120 Hz; ESR: equivalent series resistance measured at 100 kHz; DF: dissipation factor measured at 120 Hz; X(-55)/X(25): the ratio between the values of a specific characteristic property X measured at -55 °C to that measured at 25 °C. | | | | | | |

## Claims

1. A composition for forming an electroactive coating, comprising:
at least one compound of formula (1) as a monomer, 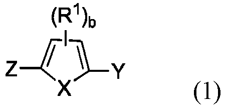
wherein
X is selected from the group consisting of S, O, Se, Te, PR² and NR², wherein R² is selected from the group consisting of hydrogen, and substituted and unsubstituted alkyl, aryl, heteroaryl, alkanoyl, and aryloyl groups;
Y is hydrogen (H), or a precursor of a leaving group Y⁻ whose conjugate acid (HY) has a pKₐ of less than 45;
Z is hydrogen (H), silyl, or a precursor of a leaving group Z⁻ whose conjugate acid (HZ) has a pKₐ of less than 45;
b is 0, 1 or 2;
each R¹ is a substituent, wherein when b=2, the two R¹ are the same or different and may j oint together to form a ring; and
the at least one compound of formula (1) comprises at least one compound of formula (1) with Z=H and Y≠H;
an acid as a polymerization catalyst selected from the group consisting of a protic acid, a polymeric acid, and a non-transitional Lewis acid; and
at least one functional component, selected from the group consisting of a solvent, a polymerization retardant, a polymer binder, a dopant, a latent dopant, a plasticizer, an impact modifier, a reinforcing filler, a blowing agent, a crosslinking agent, an ultraviolet stabilizer, a flame retardant, a photoresist, a thickening agent, a defoaming agent, an emulsifier, a surfactant, and a dispersion stabilizer,
wherein the at least one functional component contains at least the polymerization retardant and the polymer binder, and the polymerization retardant comprises at least one Lewis base having a stronger basicity than the monomer and slows down or inhibits polymerization activity of a mixture solution of the monomer and the acid as the polymerization catalyst,
the polymer binder (a) is not a polymerization retardant, or (b) comprises a polymeric acid functioning as the acid as the polymerization catalyst and functioning as the dopant; and
wherein the concentration of the monomer in the composition ranges from 1 wt% to 99 wt%, the molar ratio of the acid as the polymerization catalyst to the monomer ranges from 0.0001 to 20, the molar ratio of the polymerization retardant to the acid as the polymerization catalyst is greater than 0.0001, and the weight ratio of the polymer binder to the monomer ranges from 0.001 to 500.

2. A composition for forming an electroactive coating, comprising:
at least one compound of formula (2) as a monomer, 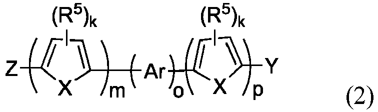
wherein
X is the same or different at each occurrence, and is independently selected from the group consisting of S, O, Se, Te, PR² and NR², wherein R² is selected from the group consisting of hydrogen, and substituted and unsubstituted alkyl, aryl, heteroaryl, alkanoyl, and aryloyl groups;
Y is hydrogen (H), or a precursor of a leaving group Y⁻ whose conjugate acid (HY) has a pKₐ of less than 45;
Z is hydrogen (H), silyl, or a precursor of a leaving group Z⁻ whose conjugate acid (HZ) has a pKₐ of less than 45;
Ar is a substituted or unsubstituted, mono- or poly-nuclear, aryl or heteroaryl ring;
m and p are each independently an integer equal to or greater than 1, and o is an integer equal to or greater than 0;
each k is independently 0, 1 or 2;
each R⁵ is a substituent, wherein any two R⁵ on the same ring or on two neighboring rings, or R⁵ and a substituent group on a neighboring Ar ring, may join together to form another ring, and
wherein the at least one compound of formula (2) comprises at least one compound of formula (2) with Z=H and Y≠H;
an acid as a polymerization catalyst selected from the group consisting of a protic acid, a polymeric acid, and a non-transitional Lewis acid;
at least one functional component selected from the group consisting of a solvent, a polymerization retardant, a polymer binder, a dopant, a latent dopant, a plasticizer, an impact modifier, a reinforcing filler, a blowing agent, a crosslinking agent, an ultraviolet stabilizer, a flame retardant, a photoresist, a thickening agent, a defoaming agent, an emulsifier, a surfactant, and a dispersion stabilizer,
wherein the at least one functional component contains at least the polymerization retardant and the polymer binder, and the polymerization retardant comprises at least one Lewis base having a stronger basicity than the monomer and slows down or inhibits polymerization activity of a mixture solution of the monomer and the acid as the polymerization catalyst,
the polymer binder (a) is not a polymerization retardant, or (b) comprises a polymeric acid functioning as the acid as the polymerization catalyst and functioning as the dopant; and
wherein the concentration of the monomer in the composition ranges from 1 wt% to 99 wt%, the molar ratio of the acid as the polymerization catalyst to the monomer ranges from 0.0001 to 20, the molar ratio of the polymerization retardant to the acid as the polymerization catalyst is greater than 0.0001, and the weight ratio of the polymer binder to the monomer ranges from 0.001 to 500.

3. The composition of claim 1 or 2, wherein the at least one Lewis base is selected from the group consisting of *O*-containing compounds, *N*-containing compounds, *S*-containing compounds and *P*-containing compounds, wherein
the *O*-containing compounds are selected from the group consisting of water, alcohols, ketones, ethers, esters, carbonates, aldehydes, anhydrides, orthosilicates, alkoxysilanes, siloxanes, and *O*-containing polymers,
the *N*-containing compounds are selected from the group consisting of amines, amides, imides, nitriles, *N*-containing heterocyclic compounds, *N*-containing heteroaromatic compounds, and *N*-containing polymers,
the *S*-containing compounds are selected from the group consisting of sulfides, sulfoxides, sulfones, sulfites, sulfates, bisulfates, and *S*-containing polymers, and
the *P*-containing compounds are selected from the group consisting of phosphines, phosphine oxides, phosphites, phosphonates, phosphates, phosphoramides, and *P*-containing polymers.

4. The composition of claim 1 or 2, wherein
the polymer binder comprises a polymeric acid functioning as the acid as the polymerization catalyst and functioning as the dopant, and
the polymeric acid is selected from substituted and unsubstituted poly(glycolic acid)s, poly(lactic acid)s, polystyrenesulfonic acids, polyacrylic acids, polymethacrylic acids, polymaleic acids, polyvinylsulfonic acids, sulfonated polystyrenes, sulfonated poly(vinyl naphthalene)s, sulfonated poly(vinyl arene)s, sulfonated poly(vinyl heteroarene)s, sulfonated copolymers or terpolymers comprising at least one aromatic functional group or one heteroaromatic functional group or one styrene repeat unit, oligophosphoric acids, polyphosphoric acids, oligometaphosphoric acids, polymetaphosphoric acids, poly(ethylene phosphate)s, and poly(propylene phosphate)s, and combination mixtures, copolymers and terpolymers thereof.

5. The composition of claim 1 or 2, wherein the polymer binder comprises a thermosetting plastic or a thermoplastic plastic.

6. The composition of claim 1 or 2, wherein
Y is selected from the group consisting of hydrogen, halogen-based, *O*-based, *N*-based, *S*-based, *P*-based, and weakly basic *C*-based substituent groups, and
Z is selected from the group consisting of hydrogen, halogen-based, *O*-based, *N*-based, *S*-based, *P*-based, *Si*-based, and weakly basic *C*-based substituent groups.

7. The composition of claim 1 or 2, wherein the polymer binder is selected from substituted and unsubstituted polyacrylates, polymethacrylates, polyacrylamides, polyacrylonitriles, polystyrenes, PMMA, PS-PMMA copolymers, poly(styrenesulfonic acid)s, poly(styrene sulfonate)s, poly(alkyl styrenesulfonate)s, polyphosphoric acid, poly(ethylene phosphate)s, poly(propylene phosphate)s, nylons, polycaprolactams, polyamides, polyvinylpyrrolidones, polyvinylpyridines, polyphosphazenes, polyesters, PET, polycaprolactones, polybutadienes, polychloroprenes, polyisoprenes, natural rubbers, polyisobutylenes, styrene-butadiene rubbers, EPDM, acrylonitrile-butadiene rubbers, ABS, isobutylene-isoprene rubbers, polyethers, polyethylene glycol)s, polyethylene oxide)s, poly(propylene glycol)s, poly(propylene oxide)s, polytetrahydrofurans, Si-O bond containing polymers, polysilicates, polysiloxanes, poly(methyl vinyl ketone)s, polyketones, polyetheretherketones, polyetherimides, polyimides, polyamideimides, polybenzimidazoles, polyureas, polyurethanes, polycarbonates, polyarylates, poly(p-xylylene)s, polyphenylene oxide)s, polyphenylene sulfide)s, polysulfones, polyacetals, polyformaldehydes, polyketals, polyacetones, poly(vinylidene fluoride)s, poly(vinyl acetate)s, poly(vinyl alcohol)s, poly[ethylene-co-(vinyl acetate)]s, poly[ethylene-co-(vinyl alcohol)]s, and the combination copolymers, terpolymers, or polymer mixtures thereof.

8. An electroactive polymer solution comprising a conjugated heteroaromatic polymer, wherein the conjugated heteroaromatic polymer is prepared from the composition of claim 1 or 2, and the electroactive polymer solution further comprises a part of the polymerization retardant in the composition.

9. An electroactive coating comprising a conjugated heteroaromatic polymer wherein the conjugated heteroaromatic polymer is prepared from the composition of claim 1 or 2, and the electroactive coating further comprises a part of the polymerization retardant in the composition.

10. The electroactive coating of claim 9, which is comprised
in electroactive objects as for antistatic, electrostatic dissipation, EMI shielding, infrared or radio frequency and microwave absorbing shields, and smart cards; or
in electronic devices as for LED, field effect transistors, organic memory devices, solar cell devices, photovoltaic cells, supercapacitors, and sensors; or
in flexible electronic articles as for flexible electronic membranes, contacts, wires, electrodes, connectors, and devices; or
in displays and electrochromic window devices for electrochromic displays, electroluminescent displays, liquid crystal displays, solar windows, smart windows, electrochromic sunroofs, electrochromic windows, electrochromic liquid crystal windows, touch panels, and touch screens; or
in corrosion-preventing coatings for corrodible materials; or
in conductive ink printings.

11. A capacitor containing an electroactive coating of claim 9.

12. A method for forming an electroactive coating, comprising:
a) contacting the composition of claim 1 or 2 with a substrate; and
b) conducting at least one of a step of raising a temperature of the substrate, a step of evaporating partly the solvent in the composition, and a step of evaporating partly or completely the polymerization retardant in the composition, so as to initiate and/or continue polymerization on a surface of the substrate and/or in a hole of the substrate and form a conjugated heteroaromatic polymer.

13. The method of claim 12 wherein step b) includes a step of evaporating partly the polymerization retardant in the composition.

14. A method for forming an electroactive coating, comprising:
performing at least one of steps of solution casting, dipping, soaking, impregnation, dropping, dripping on, squirting, spraying, doctor blade coating, roller coating, rotogravure printing, sponge roller coating, painting, and printing on a substrate or an object using the electroactive polymer solution of claim 8.

15. The method of claim 14 wherein the used electroactive polymer solution of claim 8 contains the polymerization retardant from the composition of claim 1 or 2, and the polymerization retardant comprises an *O*-containing polymer, an *N*-containing polymer, an *S*-containing polymer or a *P*-containing polymer.

16. A capacitor containing an electroactive coating prepared according to the method of claim 13 or 15.

17. The capacitor of claim 16, which comprises a radial-type capacitor, a dip-type capacitor, a SMD-type capacitor, a V-chip-type capacitor, a stacked-type capacitor, a H-chip-type capacitor, a chip-type capacitor, or a hybrid-type capacitor.

18. A method for fabricating a solid electrolytic capacitor, comprising:
forming an anode;
forming a dielectric layer on the anode; and
forming, as a solid electrolyte, an electroactive coating on the dielectric layer with the method of claim 13 or 15.

19. A solid electrolytic capacitor that is fabricated according to the method of claim 18.

## Patentansprüche

1. Zusammensetzung zum Bilden einer elektroaktiven Beschichtung, umfassend:
mindestens einer Verbindung der Formel (1) als Monomer, 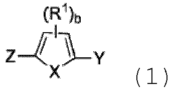
wobei
X aus der Gruppe bestehend aus S, O, Se, Te, PR² und NR² ausgewählt ist, wobei R² aus der Gruppe bestehend aus Wasserstoff und substituierten und unsubstituierten Alkyl-, Aryl-, Heteroaryl-, Alkanoyl- und Aryloylgruppen ausgewählt ist;
Y Wasserstoff (H) oder ein Vorläufer einer Abgangsgruppe Y⁻ ist, deren konjugierte Säure (HY) einen pKₐ-Wert kleiner 45 aufweist;
Z Wasserstoff (H), Silyl oder ein Vorläufer einer Abgangsgruppe Z ist, deren konjugierte Säure (HZ) einen pKₐ-Wert kleiner 45 aufweist;
b 0, 1 oder 2 ist;
R¹ jeweils ein Substituent ist, wobei, wenn b = 2, die beiden R¹ gleich oder verschieden sind und sich zu einem Ring verbinden können; und
die mindestens eine Verbindung der Formel (1) mindestens eine Verbindung der Formel (1) mit Z = H und Y ≠ H umfasst;
eine Säure als Polymerisationskatalysator, die aus der Gruppe bestehend aus einer Protonensäure, einer polymeren Säure und einer übergangsmetallfreien Lewis-Säure ausgewählt ist; und
mindestens eine funktionelle Komponente, die aus der Gruppe bestehend aus einem Lösungsmittel, einem Polymerisationsverzögerer, einem Polymerbindemittel, einem Dotierstoff, einem latenten Dotierstoff, einem Weichmacher, einem Schlagzähmodifikator, einem verstärkenden Füllstoff, einem Treibmittel, einem Vernetzungsmittel, einem Ultraviolettstabilisator, einem Flammschutzmittel, einem Fotoresist, einem Verdickungsmittel, einem Entschäumer, einem Emulgator, einem Tensid und einem Dispersionsstabilisator ausgewählt ist,
wobei die mindestens eine funktionelle Komponente mindestens den Polymerisationsverzögerer und das Polymerbindemittel enthält und der Polymerisationsverzögerer mindestens eine Lewis-Base mit einer gegenüber dem Monomer stärkeren Basizität umfasst und die Polymerisationsaktivität einer Mischungslösung des Monomers und der Säure als der Polymerisationskatalysator verlangsamt oder hemmt,
das Polymerbindemittel (a) kein Polymerisationsverzögerer ist oder (b) eine polymere Säure umfasst, die als die Säure als der Polymerisationskatalysator fungiert und als der Dotierstoff fungiert; und
wobei die Konzentration des Monomers in der Zusammensetzung im Bereich von 1 Gew.-% bis 99 Gew.-% liegt, das Molverhältnis der Säure als der Polymerisationskatalysator zu dem Monomer im Bereich von 0,0001 bis 20 liegt, das Molverhältnis des Polymerisationsverzögerers zu der Säure als der Polymerisationskatalysator größer als 0,0001 ist und das Gewichtsverhältnis des Polymerbindemittels zu dem Monomer im Bereich von 0,001 bis 500 liegt.

2. Zusammensetzung zum Bilden einer elektroaktiven Beschichtung, umfassend:
mindestens eine Verbindung der Formel (2) als Monomer, 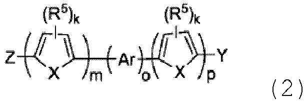
wobei
X bei jedem Auftreten gleich oder verschieden ist und unabhängig aus der Gruppe bestehend aus S, O, Se, Te, PR² und NR² ausgewählt ist, wobei R² aus der Gruppe bestehend aus Wasserstoff und substituierten und unsubstituierten Alkyl-, Aryl-, Heteroaryl-, Alkanoyl- und Aryloylgruppen ausgewählt ist;
Y Wasserstoff (H) oder ein Vorläufer einer Abgangsgruppe Y⁻ ist, deren konjugierte Säure (HY) einen pKₐ-Wert kleiner 45 aufweist;
Z Wasserstoff (H), Silyl oder ein Vorläufer einer Abgangsgruppe Z ist, deren konjugierte Säure (HZ) einen pKₐ-Wert kleiner 45 aufweist;
Ar ein substituierter oder unsubstituierter ein- oder mehrkerniger Aryl- oder Heteroarylring ist;
m und p jeweils unabhängig eine ganze Zahl gleich oder größer als 1 sind und o eine ganze Zahl gleich oder größer als 0 ist;
k jeweils unabhängig 0, 1 oder 2 ist;
R⁵ jeweils ein Substituent ist, wobei sich beliebige zwei R⁵ an demselben Ring oder an zwei benachbarten Ringen oder R⁵ und eine Substituentengruppe an einem benachbarten Ar-Ring zu einem anderen Ring verbinden können, und
wobei die mindestens eine Verbindung der Formel (2) mindestens eine Verbindung der Formel (2) mit Z = H und Y ≠ H umfasst;
eine Säure als Polymerisationskatalysator, die aus der Gruppe bestehend aus einer Protonensäure, einer polymeren Säure und einer übergangsmetallfreien Lewis-Säure ausgewählt ist; und
mindestens eine funktionelle Komponente, die aus der Gruppe bestehend aus einem Lösungsmittel, einem Polymerisationsverzögerer, einem Polymerbindemittel, einem Dotierstoff, einem latenten Dotierstoff, einem Weichmacher, einem Schlagzähmodifikator, einem verstärkenden Füllstoff, einem Treibmittel, einem Vernetzungsmittel, einem Ultraviolettstabilisator, einem Flammschutzmittel, einem Fotoresist, einem Verdickungsmittel, einem Entschäumer, einem Emulgator, einem Tensid und einem Dispersionsstabilisator ausgewählt ist,
wobei die mindestens eine funktionelle Komponente mindestens den Polymerisationsverzögerer und das Polymerbindemittel enthält und der Polymerisationsverzögerer mindestens eine Lewis-Base mit einer gegenüber dem Monomer stärkeren Basizität umfasst und die Polymerisationsaktivität einer Mischungslösung des Monomers und der Säure als der Polymerisationskatalysator verlangsamt oder hemmt,
das Polymerbindemittel (a) kein Polymerisationsverzögerer ist oder (b) eine polymere Säure umfasst, die als die Säure als der Polymerisationskatalysator fungiert und als der Dotierstoff fungiert; und
wobei die Konzentration des Monomers in der Zusammensetzung im Bereich von 1 Gew.-% bis 99 Gew.-% liegt, das Molverhältnis der Säure als der Polymerisationskatalysator zu dem Monomer im Bereich von 0,0001 bis 20 liegt, das Molverhältnis des Polymerisationsverzögerers zu der Säure als der Polymerisationskatalysator größer als 0,0001 ist und das Gewichtsverhältnis des Polymerbindemittels zu dem Monomer im Bereich von 0,001 bis 500 liegt.

3. Zusammensetzung nach Anspruch 1 oder 2, wobei die mindestens eine Lewis-Base aus der Gruppe bestehend aus O-haltigen Verbindungen, N-haltigen Verbindungen, S-haltigen Verbindungen und P-haltigen Verbindungen ausgewählt ist, wobei
die O-haltigen Verbindungen aus der Gruppe bestehend aus Wasser, Alkoholen, Ketonen, Ethern, Estern, Carbonaten, Aldehyden, Anhydriden, Orthosilikaten, Alkoxysilanen, Siloxanen und O-haltigen Polymeren ausgewählt sind,
die *N*-haltigen Verbindungen aus der Gruppe bestehend aus Aminen, Amiden, Imiden, Nitrilen, *N*-haltigen heterocyclischen Verbindungen, *N*-haltigen heteroaromatischen Verbindungen und *N-*haltigen Polymeren ausgewählt sind,
die *S*-haltigen Verbindungen aus der Gruppe bestehend aus Sulfiden, Sulfoxiden, Sulfonen, Sulfiten, Sulfaten, Bisulfaten und *S*-haltigen Polymeren ausgewählt sind, und
die *P*-haltigen Verbindungen aus der Gruppe bestehend aus Phosphinen, Phosphinoxiden, Phosphiten, Phosphonaten, Phosphaten, Phosphoramiden und *P*-haltigen Polymeren ausgewählt sind.

4. Zusammensetzung nach Anspruch 1 oder 2, wobei
das Polymerbindemittel eine polymere Säure umfasst, die als die Säure als der Polymerisationskatalysator fungiert und als der Dotierstoff fungiert; und
die polymere Säure aus substituierten und unsubstituierten Poly(glykolsäure)n, Poly(milchsäure)n, Polystyrolsulfonsäuren, Polyacrylsäuren, Polymethacrylsäuren, Polymaleinsäuren, Polyvinylsulfonsäuren, sulfonierten Polystyrolen, sulfonierten Poly(vinylnaphthalin)en, sulfonierten Poly(vinylaren)en, sulfonierten Poly(vinylheteroaren)en, sulfonierten Co- oder Terpolymeren, die mindestens eine aromatische funktionelle Gruppe oder eine heteroaromatische funktionelle Gruppe oder eine Styrolwiederholeinheit umfassen, Oligophosphorsäuren, Polyphosphorsäuren, Oligometaphosphorsäuren, Polymetaphosphorsäuren, Poly(ethylenphosphat)en und Poly(propylenphosphat)en und Kombinationsmischungen, Copolymeren und Terpolymeren davon ausgewählt ist.

5. Zusammensetzung nach Anspruch 1 oder 2, wobei das Polymerbindemittel einen duroplastischen Kunststoff oder einen thermoplastischen Kunststoff umfasst.

6. Zusammensetzung nach Anspruch 1 oder 2, wobei
Y aus der Gruppe bestehend aus Wasserstoff, Halogen-basierten, *O*-basierten, *N*-basierten, *S*-basierten,*P*-basierten und schwach basischen *C*-basierten Substituentengruppen ausgewählt ist, und
Z aus der Gruppe bestehend aus Wasserstoff, Halogen-basierten, *O*-basierten, *N*-basierten, *S*-basierten, *P*-basierten, *Si*basierten und schwach basischen *C*-basierten Substituentengruppen ausgewählt ist.

7. Zusammensetzung nach Anspruch 1 oder 2, wobei das Polymerbindemittel aus substituierten und unsubstituierten Polyacrylaten, Polymethacrylaten, Polyacrylamiden, Polyacrylnitrilen, Polystyrolen, PMMA, PS-PMMA-Copolymeren, Poly(styrolsulfonsäure)n, Poly(styrolsulfonat)en, Poly(alkylstyrolsulfonat)en, Polyphosphorsäure, Poly(ethylenphosphat)en, Poly(propylenphosphat)en, Nylonen, Polycaprolactamen, Polyamiden, Polyvinylpyrrolidonen, Polyvinylpyridinen, Polyphosphazenen, Polyestern, PET, Polycaprolactonen, Polybutadienen, Polychloroprenen, Polyisoprenen, Naturkautschuken, Polyisobutylenen, Styrol-Butadienkautschuken, EPDM, Acrylnitril-Butadien-Kautschuken, ABS, Isobutylen-Isopren-Kautschuken, Polyethern, Poly(ethylenglykol)en, Poly(ethylenoxid)en, Poly(propylenglykol)en, Poly(propylenoxid)en, Polytetrahydrofuranen, Si-O-bindungshaltigen Polymeren, Polysilikaten, Polysiloxanen, Poly(methylvinylketon)en, Polyketonen, Polyetheretherketonen, Polyetherimiden, Polyimiden, Polyamidimiden, Polybenzimidazolen, Polyharnstoffen, Polyurethanen, Polycarbonaten, Polyarylaten, Poly(p-xylylen)en, Poly(phenylenoxid)en, Poly(phenylensulfid)en, Polysulfonen, Polyacetalen, Polyformaldehyden, Polyketalen, Polyacetonen, Poly(vinylidenfluorid)en, Poly(vinylacetat)en, Poly(vinylalkohol)en, Poly[ethylen-co-(vinylacetat)en, Poly[ethylen-co-(vinylalkohol)]en und Kombinations-Copolymeren, Terpolymeren oder Polymermischungen davon ausgewählt ist.

8. Elektroaktive Polymerlösung, umfassend ein konjugiertes heteroaromatisches Polymer, wobei das konjugierte heteroaromatische Polymer aus der Zusammensetzung nach Anspruch 1 oder 2 hergestellt ist, und die elektroaktive Polymerlösung ferner einen Teil des Polymerisationsverzögerers in der Zusammensetzung umfasst.

9. Elektroaktive Beschichtung, umfassend ein konjugiertes heteroaromatisches Polymer, wobei das konjugierte heteroaromatische Polymer aus der Zusammensetzung nach Anspruch 1 oder 2 hergestellt ist, und die elektroaktive Beschichtung ferner einen Teil des Polymerisationsverzögerers in der Zusammensetzung umfasst.

10. Elektroaktive Beschichtung nach Anspruch 9, die enthalten ist
in elektroaktiven Objekten wie für Antistatika, elektrostatische Dissipation, EMI-Abschirmung, Infrarot- oder Radiofrequenz- und Mikrowellen absorbierende Abschirmungen und Chipkarten; oder
in elektronischen Vorrichtungen wie für LED, Feldeffekttransistoren, organischen Speichervorrichtungen, Solarzellenvorrichtungen, Fotovoltaikzellen, Superkondensatoren und Sensoren; oder
in flexiblen elektronischen Gegenständen wie für flexible elektronische Membranen, Kontakte, Drähte, Elektroden, Verbinder und Vorrichtungen; oder
in Anzeigen und elektrochromen Fenstervorrichtungen für elektrochrome Anzeigen, elektrolumineszierenden Anzeigen, Flüssigkristallanzeigen, Solarfenstern, Smart-Fenstern, elektrochromen Schiebedächern, elektrochromen Fenstern, elektrochromen Flüssigkristallfenstern, Touchpanels und Touchscreens; oder
in korrosionsschützenden Beschichtungen für korrodierbare Materialien oder
in leitfähigen Tintendrucken.

11. Kondensator, enthaltend eine elektroaktive Beschichtung nach Anspruch 9.

12. Verfahren zum Bilden einer elektroaktiven Beschichtung, umfassend:
a) Inkontaktbringen der Zusammensetzung nach Anspruch 1 oder 2 mit einem Substrat; und
b) Durchführen von mindestens einem von einem Schritt des Anhebens einer Temperatur des Substrats, einem Schritt des teilweisen Verdampfens des Lösungsmittels in der Zusammensetzung und einem Schritt des teilweisen oder vollständigen Verdampfens des Polymerisationsverzögerers in der Zusammensetzung, um die Polymerisation auf einer Oberfläche des Substrats und/oder in einem Loch des Substrats zu initiieren und/oder fortzusetzen und ein konjugiertes heteroaromatisches Polymer zu bilden.

13. Verfahren nach Anspruch 12, wobei Schritt b) einen Schritt des teilweisen Verdampfens des Polymerisationsverzögerers in der Zusammensetzung beinhaltet.

14. Verfahren zum Bilden einer elektroaktiven Beschichtung, umfassend:
Durchführen mindestens einer der Schritte des Lösungsgießens, Tauchens, Tränkens, Imprägnierens, Absenkens, Auftropfens, Spritzens, Sprühens, Rakelbeschichtens, Walzenbeschichtens, Tiefdruckens, Schwammwalzenbeschichtens, Lackierens und Bedruckens auf einem Substrat oder einem Objekt unter Verwendung der elektroaktiven Polymerlösung nach Anspruch 8.

15. Verfahren nach Anspruch 14, wobei die verwendete elektroaktive Polymerlösung nach Anspruch 8 den Polymerisationsverzögerer aus der Zusammensetzung nach Anspruch 1 oder 2 enthält, und der Polymerisationsverzögerer ein O-haltiges Polymer, ein N-haltiges Polymer, ein S-haltiges Polymer oder ein P-haltiges Polymer umfasst.

16. Kondensator, enthaltend eine elektroaktive Beschichtung, hergestellt gemäß dem Verfahren nach Anspruch 13 oder 15.

17. Kondensator nach Anspruch 16, der einen Radial-Kondensator, einen Dip-Kondensator, einen SMD-Kondensator, einen V-Chip-Kondensator, einen Stapel-Kondensator, einen H-Chip-Kondensator, einen Chip-Kondensator oder einen Hybrid-Kondensator umfasst.

18. Verfahren zum Herstellen eines Festelektrolytkondensators, umfassend:
Bilden einer Anode;
Bilden einer dielektrischen Schicht auf der Anode; und
Bilden einer elektroaktiven Beschichtung auf der dielektrischen Schicht als Festelektrolyt mit dem Verfahren nach Anspruch 13 oder 15.

19. Festelektrolytkondensator, der gemäß dem Verfahren nach Anspruch 18 hergestellt ist.

## Revendications

1. Composition pour la formation d'un revêtement électroactif, comprenant :
au moins un composé de formule (1) à titre de monomère, 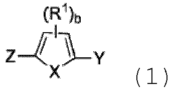
dans laquelle
X est choisi dans le groupe constitué par S, O, Se, Te, PR² et NR², où R² est choisi dans le groupe constitué par l'hydrogène, et les groupes alkyle, aryle, hétéroaryle, alcanoyle et aryloyle substitués et non substitués ;
Y est l'hydrogène (H), ou un précurseur d'un groupe partant Y⁻ dont l'acide conjugué (HY) a un pKₐ inférieur à 45 ;
Z est l'hydrogène (H), silyle, ou un précurseur d'un groupe partant Z dont l'acide conjugué (HZ) a un pKₐ inférieur à 45 ;
b est 0, 1 ou 2 ;
chaque R¹ est un substituant, dans laquelle lorsque b=2, les deux R¹ sont identiques ou différents et peuvent se lier ensemble pour former un cycle ; et
l'au moins un composé de formule (1) comprend au moins un composé de formule (1) avec Z=H et Y≠H ;
un acide comme catalyseur de polymérisation choisi dans le groupe constitué par un acide protique, un acide polymérique et un acide de Lewis non transitionnel ; et
au moins un composant fonctionnel, choisi dans le groupe constitué par un solvant, un retardateur de polymérisation, un liant polymère, un dopant, un dopant latent, un plastifiant, un modifiant choc, une charge renforçante, un agent gonflant, un agent de réticulation, un stabilisant ultraviolet, un retardateur de flamme, une photorésine, un agent épaississant, un agent antimousse, un émulsifiant, un tensioactif, et un stabilisant de dispersion,
dans laquelle l'au moins un composant fonctionnel contient au moins le retardateur de polymérisation et le liant polymère, et le retardateur de polymérisation comprend au moins une base de Lewis ayant une basicité plus forte que le monomère et ralentit ou inhibe l'activité de polymérisation d'une solution mixte du monomère et de l'acide comme catalyseur de polymérisation,
le liant polymère (a) n'est pas un retardateur de polymérisation, ou (b) comprend un acide polymère fonctionnant comme l'acide comme catalyseur de polymérisation et fonctionnant comme dopant ; et
dans laquelle la concentration du monomère dans la composition est comprise entre 1 % en poids et 99 % en poids, le rapport molaire de l'acide en tant que catalyseur de polymérisation au monomère est compris entre 0,0001 et 20, le rapport molaire du retardateur de polymérisation à l'acide en tant que catalyseur de polymérisation est supérieur à 0,0001, et le rapport pondéral du liant polymère au monomère est compris entre 0,001 et 500.

2. Composition pour la formation d'un revêtement électroactif, comprenant :
au moins un composé de formule (2) à titre de monomère, 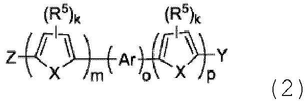
dans laquelle
X est identique ou différent à chaque occurrence, et est indépendamment choisi dans le groupe constitué par S, O, Se, Te, PR² et NR², où R² est choisi dans le groupe constitué par l'hydrogène, et les groupes alkyle, aryle, hétéroaryle, alcanoyle et aryloyle substitués et non substitués ;
Y est l'hydrogène (H), ou un précurseur d'un groupe partant Y⁻ dont l'acide conjugué (HY) a un pKₐ inférieur à 45 ;
Z est l'hydrogène (H), silyle, ou un précurseur d'un groupe partant Z dont l'acide conjugué (HZ) a un pKₐ inférieur à 45 ;
Ar est un cycle aryle ou hétéroaryle, mono- ou polynucléaire, substitué ou non ;
m et p sont chacun indépendamment un entier supérieur ou égal à 1, et o est un entier supérieur ou égal à 0 ;
chaque k vaut indépendamment 0, 1 ou 2 ;
chaque R⁵ est un substituant, dans laquelle deux R⁵ quelconques sur un même cycle ou sur deux cycles voisins, ou R⁵ et un groupe substituant sur un cycle Ar voisin, peuvent se réunir pour former un autre cycle, et
dans laquelle l'au moins un composé de formule (2) comprend au moins un composé de formule (2) avec Z=H et Y≠H ;
un acide comme catalyseur de polymérisation choisi dans le groupe constitué par un acide protique, un acide polymérique et un acide de Lewis non transitionnel ;
au moins un composant fonctionnel, choisi dans le groupe constitué par un solvant, un retardateur de polymérisation, un liant polymère, un dopant, un dopant latent, un plastifiant, un modifiant choc, une charge renforçante, un agent gonflant, un agent de réticulation, un stabilisant ultraviolet, un retardateur de flamme, une photorésine, un agent épaississant, un agent antimousse, un émulsifiant, un tensioactif, et un stabilisant de dispersion,
dans laquelle l'au moins un composant fonctionnel contient au moins le retardateur de polymérisation et le liant polymère, et le retardateur de polymérisation comprend au moins une base de Lewis ayant une basicité plus forte que le monomère et ralentit ou inhibe l'activité de polymérisation d'une solution mixte du monomère et de l'acide comme catalyseur de polymérisation,
le liant polymère (a) n'est pas un retardateur de polymérisation, ou (b) comprend un acide polymère fonctionnant comme l'acide comme catalyseur de polymérisation et fonctionnant comme dopant ; et
dans laquelle la concentration du monomère dans la composition est comprise entre 1 % en poids et 99 % en poids, le rapport molaire de l'acide en tant que catalyseur de polymérisation au monomère est compris entre 0,0001 et 20, le rapport molaire du retardateur de polymérisation à l'acide en tant que catalyseur de polymérisation est supérieur à 0,0001, et le rapport pondéral du liant polymère au monomère est compris entre 0,001 et 500.

3. Composition selon la revendication 1 ou 2, dans laquelle l'au moins une base de Lewis est choisie parmi les composés contenant *O*, les composés contenant *N*, les composés contenant *S* et les composés contenant *P*, dans laquelle
les composés contenant *O* sont choisis dans le groupe constitué par l'eau, les alcools, les cétones, les éthers, les esters, les carbonates, les aldéhydes, les anhydrides, les orthosilicates, les alcoxysilanes, les siloxanes, les polymères contenant *O*,
les composés contenant *N* sont choisis dans le groupe constitué par les amines, les amides, les imides, les nitriles, les composés hétérocycliques contenant *N*, les composés hétéroaromatiques contenant *N* et les polymères contenant *N*,
les composés contenant *S* sont choisis dans le groupe constitué par les sulfures, les sulfoxydes, les sulfones, les sulfites, les sulfates, les bisulfates, les polymères contenant *S*, et
les composés contenant *P* sont choisis dans le groupe constitué par les phosphines, les oxydes de phosphine, les phosphites, les phosphonates, les phosphates, les phosphoramides et les polymères contenant *P*.

4. Composition selon la revendication 1 ou 2, dans laquelle le liant polymère comprend un acide polymère fonctionnant comme l'acide comme catalyseur de polymérisation et fonctionnant comme dopant, et
l'acide polymérique est choisi parmi les poly(acide glycolique), les poly(acide lactique), les acides polystyrène sulfoniques, les acides polyacryliques, les acides polyméthacryliques, les acides polymaléïques, les acides polyvinylsulfoniques, les acides polystyrènes sulfonés, les poly(vinyl naphtalène) sulfonés, les poly(vinyl arène) sulfonés, les poly(vinyl hétéroarène) sulfonés, les copolymères ou terpolymères sulfonés substitués et non substitués comprenant au moins un groupe fonctionnel aromatique ou un groupe fonctionnel hétéroaromatique ou un motif répétitif styrène, les acides oligophosphoriques, les acides polyphosphoriques, les acides oligométaphosphoriques, les acides polymétaphosphoriques, les poly(éthylène phosphate), et les poly(propylène phosphate), et leurs mélanges, copolymères et terpolymères combinés.

5. Composition selon la revendication 1 ou 2, dans laquelle le liant polymère comprend une matière plastique thermodurcissable ou une matière plastique thermoplastique.

6. Composition selon la revendication 1 ou 2, dans laquelle Y est choisi dans le groupe constitué par l'hydrogène, les groupes substituants à base d'halogène, à base de *O*, à base de *N*, à base de *S,* à base de *P* et à base de C faiblement basique, et
Z est choisi dans le groupe constitué par l'hydrogène, les groupes substituants à base d'halogène, à base de *O*, à base de *N*, à base de *S,* à base de *P*, à base de *Si* et à base de *C* faiblement basique.

7. Composition selon la revendication 1 ou 2, dans laquelle le liant polymère est choisi parmi les polyacrylates, les polyméthacrylates, les polyacrylamides, les polyacrylonitriles, les polystyrènes, les PMMA, les copolymères PS-PMMA, les poly(acides styrènes sulfonates), les poly(styrène sulfonate), les poly(alkyl styrène sulfonate), l'acide polyphosphorique, les poly(éthylène phosphate), les poly(propylène phosphate), les nylons, les polycaprolactames, les polyamides, les polyvinylpyrrolidones, les polyvinylpyridines, les polyphosphazènes, les polyesters, les PET, les polycaprolactones, les polybutadiènes, les polychloroprènes, les polyisoprènes, les caoutchoucs naturels, les polyisobutylènes, les caoutchoucs styrène-butadiène, les EPDM, les caoutchoucs acrylonitrile-butadiène, les ABS, les caoutchoucs isobutylène-isoprène, les polyéthers, les poly(éthylène glycol), les poly(éthylène oxyde), poly(propylène glycol), les poly(propylène oxyde), les polytétrahydrofuranes, les polymères contenant des liaisons Si-O, les polysilicates, les polysiloxanes, les poly(méthylvinylcétone), les polycétones, les polyéthercétones, les polyétherimides, les polyimides, les polyamideimides, les polybenzimidazoles, les polyurées, les polyuréthanes, les polycarbonates, les polyarylates, les poly(p-xylylène), les poly(oxyde de phénylène), les poly(sulfure de phénylène), les polysulfones, les polyacétals, les polyformaldéhydes, les polycétals, les polyacétones, les poly(fluorure de vinylidène), les poly(acétate de vinyle), les poly(alcool de vinyle), les poly[éthylène-co-(acétate de vinyle)], les poly[éthylène-co-(alcool de vinyle)]s substitués ou non, et leurs copolymères, terpolymères ou mélanges de polymères associés.

8. Solution de polymère électroactif comprenant un polymère hétéroaromatique conjugué, dans laquelle le polymère hétéroaromatique conjugué est préparé à partir de la composition selon la revendication 1 ou 2, et la solution de polymère électroactif comprend également une partie du retardateur de polymérisation dans la composition.

9. Revêtement électroactif comprenant un polymère hétéroaromatique conjugué, dans lequel le polymère hétéroaromatique conjugué est préparé à partir de la composition selon la revendication 1 ou 2, et le revêtement électroactif comprend également une partie du retardateur de polymérisation dans la composition.

10. Revêtement électroactif selon la revendication 9, qui comprend
dans les objets électroactifs comme pour les écrans antistatiques, de dissipation électrostatique, de blindage contre les EMI, les écrans absorbant les infrarouges ou les radiofréquences et les micro-ondes, et les cartes à puce ; ou
dans les dispositifs électroniques comme pour les LED, les transistors à effet de champ, les dispositifs à mémoire organique, les dispositifs à cellules solaires, les cellules photovoltaïques, les supercondensateurs et les capteurs ; ou
dans les articles électroniques souples comme pour les membranes électroniques souples, les contacts, les fils, les électrodes, les connecteurs et les dispositifs ; ou
dans les afficheurs et les dispositifs de fenêtre électrochromes pour afficheurs électrochromes, afficheurs électroluminescents, afficheurs à cristaux liquides, fenêtres solaires, fenêtres intelligentes, toits ouvrants électrochromes, fenêtres électrochromes, fenêtres à cristaux liquides électrochromes, panneaux tactiles et écrans tactiles ; ou
dans les revêtements anticorrosion pour matériaux corrodables ; ou
dans les impressions à encre conductrice.

11. Condensateur à revêtement électroactif selon la revendication 9.

12. Procédé de formation d'un revêtement électroactif, comprenant :
a) la mise en contact de la composition selon la revendication 1 ou 2 avec un substrat ; et
b) la réalisation d'au moins une étape parmi une étape d'élévation d'une température du substrat, une étape d'évaporation partielle du solvant dans la composition, et une étape d'évaporation partielle ou totale du retardateur de polymérisation dans la composition, de manière à initier et/ou poursuivre la polymérisation sur une surface du substrat et/ou dans un trou du substrat et former un polymère hétéroaromatique conjugué.

13. Procédé selon la revendication 12, dans lequel l'étape b) comprend une étape d'évaporation partielle du retardateur de polymérisation dans la composition.

14. Procédé de formation d'un revêtement électroactif, comprenant :
la réalisation d'au moins l'une des étapes de coulée en solution, trempage, trempage en profondeur, imprégnation, chute, égouttage, projection, revêtement de racle, revêtement de rouleau, impression héliogravure, revêtement de rouleau éponge, peinture, et impression sur un substrat ou un objet à l'aide de la solution de polymère électroactif selon la revendication 8.

15. Procédé selon la revendication 14, dans lequel la solution de polymère électroactif utilisée selon la revendication 8 contient le retardateur de polymérisation de la composition selon la revendication 1 ou 2, le retardateur de polymérisation comprend un polymère contenant *O,* un polymère contenant *N,* un polymère contenant *S* ou un polymère contenant P.

16. Condensateur à revêtement électroactif préparé selon le procédé selon la revendication 13 ou 15.

17. Condensateur selon la revendication 16, qui comprend un condensateur de type radial, un condensateur de type dip, un condensateur de type SMD, un condensateur de type puce V, un condensateur de type empilé, un condensateur de type puce H, un condensateur de type puce ou un condensateur de type hybride.

18. Procédé de fabrication d'un condensateur électrolytique solide, comprenant :
la formation d'une anode ;
la formation d'une couche diélectrique sur l'anode ; et
la formation, en tant qu'électrolyte solide, d'un revêtement électroactif sur la couche diélectrique avec le procédé selon la revendication 13 ou 15.

19. Condensateur électrolytique solide qui est fabriqué selon le procédé selon la revendication 18.
